# EUROPEAN PATENT APPLICATION

(11) **EP 4 472 383 A1**
(43) Date of publication of application: **04.12.2024**
(21) Application number: 24178780.3
(22) Date of filing: 29.05.2024
(51) Int. Cl.: H10K 59/131

(54) **ELECTRONIC DEVICE**

(30) Priority: 01.06.2023 KR 20230071109; 29.08.2023 KR 20230113343
(71) Applicant: Samsung Display Co., Ltd., Yongin-si, Gyeonggi-do 17113 (KR)
(72) Inventor: Lee, Jeongho, Giheung-gu, Yongin-si 17113 (KR); Kim, Deokhoi, Giheung-gu, Yongin-si 17113 (KR); Kim, Swae-Hyun, Giheung-gu, Yongin-si 17113 (KR); Lhee, Zail, Giheung-gu, Yongin-si 17113 (KR); Moon, Youhan, Giheung-gu, Yongin-si 17113 (KR); Hong, Hyun Seok, Giheung-gu, Yongin-si 17113 (KR)
(74) Representative: Dr. Weitzel & Partner

(57) **Abstract**

An electronic device including a base layer including a first area (TT') and a second area , a first group of pixels (E11M, E13M-1) in the first area and a second group of pixels in the second area, wherein each pixel from among the first group of pixels and the second group of pixels includes a pixel circuit (PC1-1, PC2-1, PC2-1, PC2-2) and a light emitting element (E11M, E13M-1) connected to the pixel circuit, and each of the data lines (DL) being connected to the pixel circuits arranged along a first direction (DR1), wherein the first area includes circuit areas (PA1, PA2) and transmissive areas (TA) arranged alternately along the first direction, wherein the pixel circuits (PC1-1, PC2-1, PC2-1, PC2-2) in the first group of pixels are arranged in the circuit areas (PA1, PA2), wherein the data lines (DL) include first patterns (D-T) at least partially overlapping the transmissive areas (TA) and second patterns (D-M) overlapping the circuit areas (PA1, PA2), wherein the first patterns (D-T) and the second patterns (D-M) include different materials.

## Description

### BACKGROUND

### 1. Field

Embodiments of the present invention described herein relate to an electronic device, and more particularly, relate to an electronic device including an area with improved transmittance.

### 2. Description of the Related Art

An electronic device is activated in response to an electrical signal. The electronic device may include devices composed of various electronic components, such as a display unit that displays an image or a sensing unit that senses an external input. The electronic components may be electrically connected to each other via variously arranged signal lines.

### SUMMARY

Embodiments of the present invention provide an electronic device including an area with improved transmittance within an active area.

The invention is defined by independent claim 1. According to the invention, an electronic device includes a base layer including a first area and a second area having a lower optical transmittance than the first area, a first group of pixels in the first area and a second group of pixels in the second area, wherein each pixel from among the first group of pixels and the second group of pixels includes a pixel circuit including transistors and conductive patterns and a light emitting element connected to the pixel circuit; and data lines extending in a first direction, each of the data lines being connected to the pixel circuits arranged along the first direction, wherein the first area includes circuit areas and transmissive areas arranged alternately along the first direction and extending in a second direction intersecting the first direction, wherein the pixel circuits in the first group of pixels in the circuit areas are spaced from the transmissive areas, wherein the data lines include first patterns at least partially overlapping the transmissive areas and second patterns overlapping the circuit areas, wherein the first patterns and the second patterns include different materials.

The first patterns may include a transparent conductive oxide, the second patterns may include sequentially stacked first, second, and third layers, and the first layer and the third layer include titanium, and the second layer may include aluminum.

The electronic device may further include a lower insulating layer covering the first patterns, an intermediate insulating layer on the lower insulating layer, the second patterns being on the intermediate insulating layer, and an upper insulating layer on the intermediate insulating layer and covering the second patterns.

When used the term pattern in the following, one pattern of the patterns or the patterns may be understood. In other words, the patterns may be also called as pattern.

The second pattern, also called as second patterns, may be connected to the first pattern, also called as first patterns, via a contact hole in the lower insulating layer and the intermediate insulating layer.

The electronic device may further include a bridge pattern located on the lower insulating layer overlapping the circuit areas and between the corresponding first pattern and the corresponding second pattern, and the bridge pattern may be connected to the first pattern via a first contact hole in the lower insulating layer, and the second pattern may be connected to the bridge pattern via a second contact hole in the intermediate insulating layer.

The first patterns may be inside the lower insulating layer.

The lower insulating layer may include a first insulating layer including silicon oxide, and a second insulating layer on the first insulating layer and including silicon nitride, and the first patterns may be on the first insulating layer and covered by the second insulating layer.

A thickness of the first insulating layer may be greater than a thickness of the second insulating layer.

The electronic device may further include a lower insulating layer including the first patterns, an intermediate insulating layer on the lower insulating layer, the second patterns being on the intermediate insulating layer, and an upper insulating layer on the intermediate insulating layer and covering the second patterns.

The electronic device may further include a bridge pattern on the lower insulating layer and in direct contact with the corresponding first pattern, and the second pattern may be connected to the bridge pattern via a contact hole in the intermediate insulating layer.

Each of the light emitting elements may include a first electrode, a second electrode on the first electrode, and a light emitting layer between the first electrode and the second electrode, and the second electrode may be common to the light emitting elements.

Electrode holes penetrating the second electrode may be in the second electrode overlapping the transmissive areas.

The electronic device may further include coating patterns in the electrode holes.

Each of the coating patterns may have a circular shape or a polygonal shape.

At least one portion of the first pattern may overlap the corresponding coating pattern.

Each of the first group of pixels and the second group of pixels may have unit pixels arranged along the first direction, the unit pixels may include a first pixel configured to emit a first color light, a second pixel configured to emit a second color light, a third-first pixel configured to emit a third color light, and a third-second pixel configured to emit the third color light, and the first pixel and the second pixel may be spaced from each other along the second direction, and the third-first pixel and the third-second pixel may be spaced from each other in a diagonal direction intersecting the first direction and the second direction, with the first pixel in between.

Some of the pixel circuits in the second group of pixels may be aligned with the transmissive areas along the second direction.

Some of the transistors may include an oxide semiconductor pattern and some other ones of the transistors may include a silicon semiconductor pattern.

The electronic device may further include a camera module under the base layer and overlapping the second area.

The base layer may further include a hole area having higher optical transmittance than the first area and extending through at least a portion of the base layer, and the electronic device may further include at least one infrared ray sensor (IR sensor) under the base layer and overlapping the hole area.

### BRIEF DESCRIPTION OF THE DRAWINGS

The above and other aspects and features of embodiments of the present invention will become apparent by describing in detail embodiments thereof with reference to the accompanying drawings.
FIG. 1 is a perspective view of an electronic device according to one or more embodiments of the present invention.
FIG. 2A is an exploded perspective view of an electronic device according to one or more embodiments of the present invention.
FIG. 2B is a block diagram of an electronic device according to one or more embodiments of the present invention.
FIG. 3A is a block diagram of a display device according to one or more embodiments.
FIG. 3B is an equivalent circuit diagram of a pixel according to one or more embodiments.
FIG. 4 is a plan view of an active area according to one or more embodiments of the present invention.
FIG. 5 is a cross-sectional view taken along the line I-I' in FIG. 4.
FIG. 6 is an enlarged plan view of an area TT' in FIG. 4.
FIG. 7 is a cross-sectional view of a display panel taken along the line II-II' in FIG. 6 according to one or more embodiments of the present invention.
FIG. 8 is a cross-sectional view of a display panel taken along the line II-II' in FIG. 6 according to one or more embodiments of the present invention.
FIG. 9 is a cross-sectional view of a display panel taken along the line II-II' in FIG. 6 according to one or more embodiments of the present invention.
FIG. 10 is a cross-sectional view of a display panel taken along the line II-II' in FIG. 6 according to one or more embodiments of the present invention.
FIG. 11 is a plan view showing components included in one pixel circuit according to one or more embodiments.
FIGS. 12A to 12H are plan views showing components included in one pixel circuit in a stacked order.
FIGS. 13A to 13H are cross-sectional views showing a method of manufacturing an electronic device according to one or more embodiments of the present invention.

### DETAILED DESCRIPTION

As used herein, when a component (or a region, a layer, a portion, and the like) is referred to as being "on", "connected to", or "coupled to" another component, it means that the component may be directly disposed/connected/coupled on another component or a third component may be disposed between the component and another component.

Like reference numerals refer to like components. In addition, in the drawings, thicknesses, ratios, and dimensions of components are exaggerated for effective description of technical content. In the specification, "and/or" includes all of one or more combinations that the associated components may define.

Terms such as first, second, and the like may be used to describe various components, but the components should not be limited by the terms. The above terms are used only for the purpose of distinguishing one component from another. For example, without departing from the scope of the present invention, a first component may be named as a second component, and similarly, the second component may also be named as the first component. The singular expression includes the plural expression unless the context clearly dictates otherwise.

In addition, terms such as "beneath", "below", "on", "above" are used to describe the relationship of the components shown in the drawings. The above terms are relative concepts, and are described with reference to directions indicated in the drawings.

It should be understood that terms such as "include" or "have" are intended to specify that a feature, a number, a step, an operation, a component, a part, or a combination thereof described herein is present, and do not preclude a possibility of addition or existence of one or more other features or numbers, steps, operations, components, parts, or combinations thereof.

Unless otherwise defined, all terms including technical and scientific terms used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the present invention will be described with reference to the drawings.

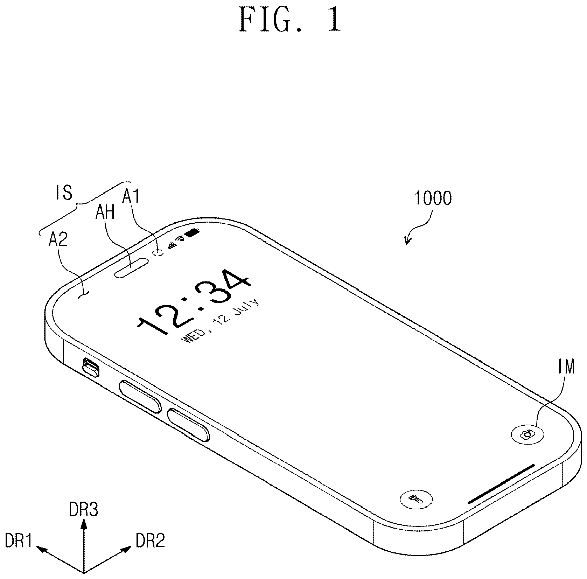

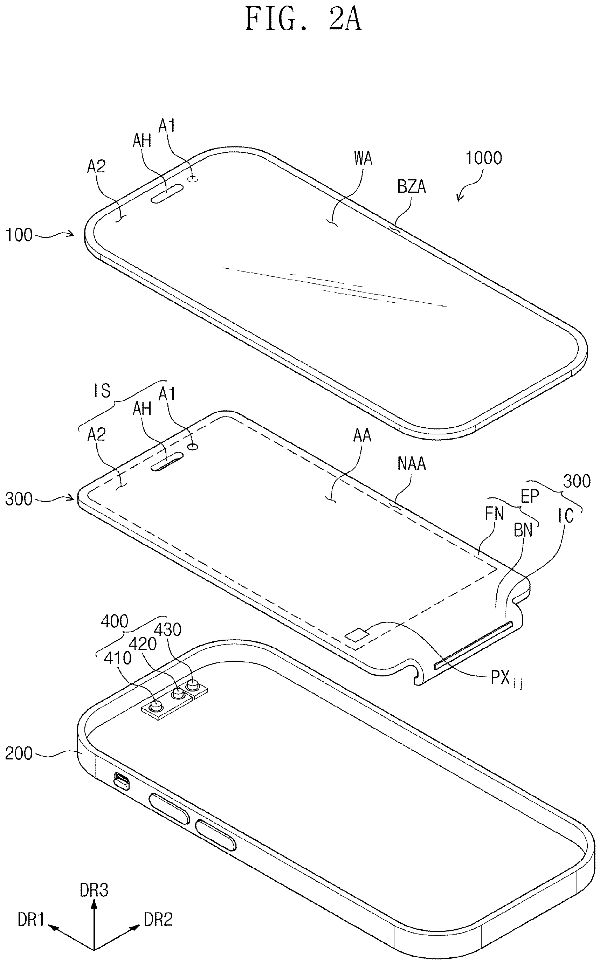

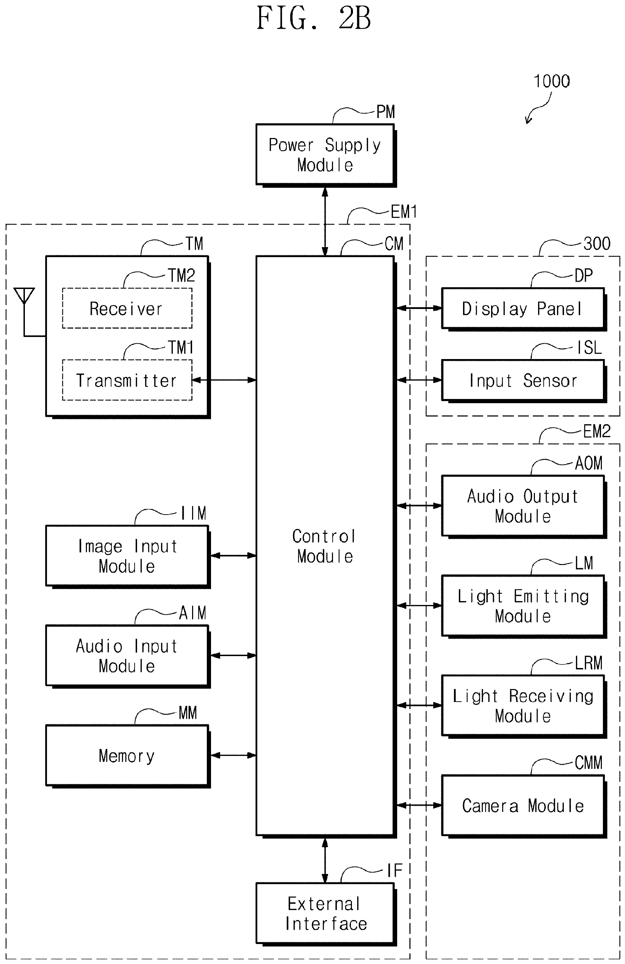

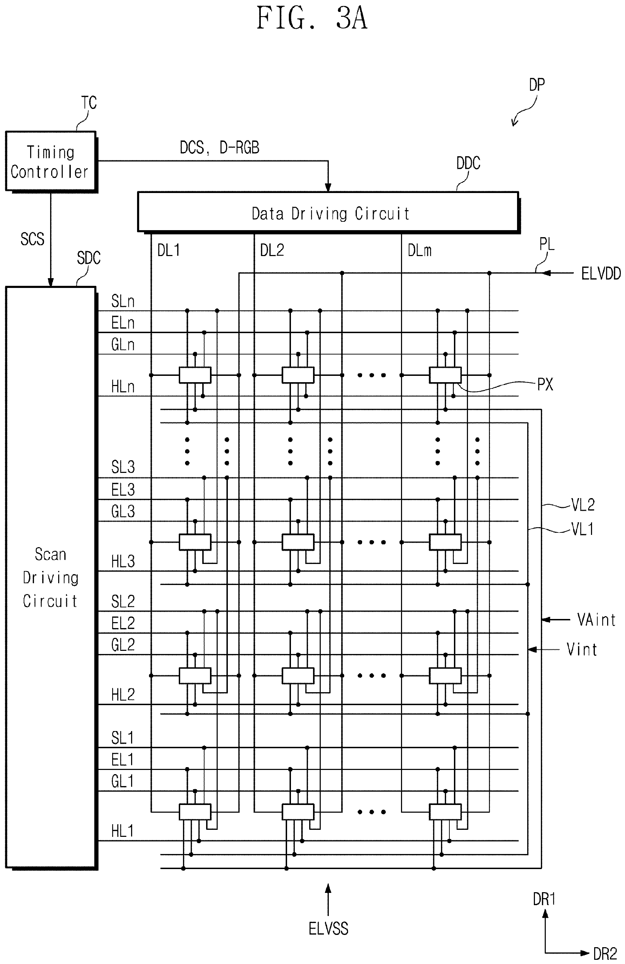

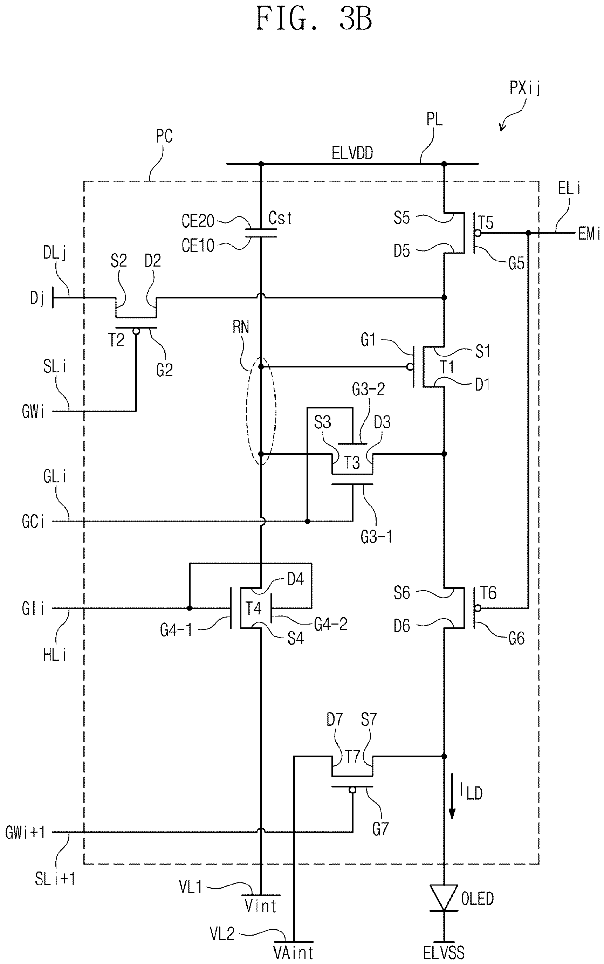

FIG. 1 is a perspective view of an electronic device according to one or more embodiments of the present invention. FIG. 2A is an exploded perspective view of an electronic device according to one or more embodiments of the present invention. FIG. 2B is a block diagram of an electronic device according to one or more embodiments of the present invention. FIG. 3A is a block diagram of a display device according to one or more embodiments. FIG. 3B is an equivalent circuit diagram of a pixel according to one or more embodiments.

An electronic device 1000 may be a device that is activated in response to an electrical signal. The electronic device 1000 may include various embodiments. For example, the electronic device 1000 may include a tablet, a laptop, a computer, a smart television, and/or the like. In the present invention, the electronic device 1000 may be, for example, a smart phone.

The electronic device 1000 may display an image IM in a third direction DR3 on a display surface IS parallel to each of a first direction DR1 and a second direction DR2. The display surface IS on which the image IM is displayed may correspond to a front surface of the electronic device 1000 and may be provided from a window 100. The image IM provided on the display surface IS may include a still image as well as a dynamic image or a moving image. In FIG. 1, as an example of the image IM, a clock and icons that may execute a plurality of applications are shown.

In the present embodiment (e.g., FIGS. 1 and 2A), a front surface (or a top surface) and a rear surface (or a bottom surface) of each member are defined based on the direction in which the image IM is displayed. The front surface and the rear surface may be opposed to each other in the third direction DR3, and normal directions of the respective front and rear surfaces may be parallel to the third direction DR3. A separation distance between the front surface and the rear surface in the third direction DR3 may correspond to a thickness of a display panel DP in the third direction DR3.

The electronic device 1000 according to one or more embodiments of the present invention may sense an input of a user applied from the outside. The input of the user includes various types of external inputs, such as a body part of the user, light, a heat, or a pressure. The electronic device 1000 according to one or more embodiments may sense the input of the user applied to a side surface or a rear surface of the electronic device 1000 depending on a structure of the electronic device 1000, and the present invention may not be limited to any one embodiment. The display surface IS of the electronic device 1000 according to the present invention may include a first area A1, a second area A2, and a hole area AH having different optical transmittances. A description thereof will be provided later.

Referring to FIG. 2A, the electronic device 1000 includes the window 100, a housing 200, a display module 300, and an electronic module 400. In the present embodiment, the window 100 and the housing 200 are combined with each other to accommodate the display module 300 and the electronic module 400 in a space defined therebetween and constitute an outer appearance of the electronic device 1000.

The window 100 may include an insulating panel. For example, the window 100 may be composed of glass, plastic, and/or a combination thereof.

As described above, a front surface of the window 100 may provide the display surface IS of the electronic device 1000. The front surface of the window 100 may be divided into a light transmissive area WA and a bezel area BZA around an edge or periphery of the light transmissive area WA. The light transmissive area WA may be an optically transparent area. For example, the light transmissive area WA may be an area with visible transmittance equal to or higher than about 90%.

The bezel area BZA may be an area with relatively low light transmittance compared to the light transmissive area WA. The bezel area BZA defines a shape of the light transmissive area WA. The bezel area BZA may be adjacent to the light transmissive area WA and may surround the light transmissive area WA.

The bezel area BZA may have a suitable color (e.g., a predetermined color). The bezel area BZA may be defined by a bezel layer provided separately from a transparent substrate defining the light transmissive area WA, or by an ink layer formed by being inserted into or colored in the transparent substrate. In the electronic device 1000 according to one or more embodiments, the bezel area BZA may be around (e.g., may surround) only a portion of the light transmissive area WA or may be omitted, but the present invention may not be limited to any one embodiment.

The display module 300 may include an electronic panel EP and a driving circuit IC.

The electronic panel EP may display the image IM and sense the external input. The display surface IS of the electronic panel EP includes an active area AA and a peripheral area NAA around an edge or periphery of the active area AA. The active area AA may be an area that is activated in response to the electrical signal. In the present embodiment, most of the active area AA may be an area where the image IM is displayed, and at the same time, may be an area where the external input is sensed. The active area AA may be an area where a plurality of pixels PXij, which will be described later, are arranged.

According to one or more embodiments, the first area A1 of the active area AA may have higher optical transmittance than the second area A2. Therefore, an image quality of the image provided in the first area A1 may be relatively lower than that provided in the second area A2. The hole area AH may have higher optical transmittance than the first area A1. The hole area AH may be defined through an area of the electronic panel EP overlapping the hole area AH. Therefore, the image IM may not be provided in the hole area AH of the active area AA.

The light transmissive area WA overlaps at least the active area AA. For example, the light transmissive area WA overlaps a front surface or at least a portion of the active area AA. Accordingly, the user may view the image IM or provide the external input via the light transmissive area WA. However, this is shown as an example, and an area where the image IM is displayed and an area where the external input is sensed may be separated from each other within the active area AA, and the present invention may not be limited to any one embodiment.

The peripheral area NAA may be an area covered by the bezel area BZA. The peripheral area NAA is adjacent to the active area AA. The peripheral area NAA may surround the active area AA. The peripheral area NAA may be an area where the image IM is not displayed. The driving circuit, driving wiring, and the like to operate the active area AA may be disposed in the peripheral area NAA.

According to one or more embodiments, a portion of the peripheral area NAA of the electronic panel EP may be bent. The electronic panel EP may include a flat portion FN and a bendable portion BN. The flat portion FN may be assembled in a state substantially parallel to a plane defined by the first direction DR1 and the second direction DR2. The active area AA may be provided in the flat portion FN.

The bendable portion BN may extend from the flat portion FN and may be bent. The bendable portion BN may be bent from the flat portion FN and assembled to be located on a rear side of the flat portion FN. When being assembled, the bendable portion BN overlaps the flat portion FN on a plane (e.g., the bendable portion BN overlaps the flat portion FN in the third direction DR3), so that the bezel area of the electronic device 1000 may be reduced. This is an example illustration, and the bendable portion BN may be omitted in the electronic panel EP. However, the present invention may not be limited thereto, and the electronic panel EP may be assembled in a flat state with the active area AA and the peripheral area NAA facing the window 100.

The driving circuit IC may be mounted on the bendable portion BN. The driving circuit IC is shown as an embodiment provided in a form of a chip, but the present invention is not limited thereto. The driving circuit IC may be provided on a separate circuit board and electrically connected to the electronic panel EP via a flexible film and/or the like.

The driving circuit IC is electrically connected to the active area AA and transmits the electrical signal to the active area AA. For example, the driving circuit IC may include a data driving circuit and may provide data signals to pixels arranged in the active area AA. Alternatively, the driving circuit IC may include a touch driving circuit and may be electrically connected to an input sensor disposed in the active area AA. This is an example illustration, and the driving circuit IC may be designed to include various circuits in addition to the above-mentioned circuits or to provide various electrical signals to the active area AA, and the present invention may not be limited to any one embodiment.

In one or more embodiments, the electronic device 1000 may further include a main circuit board electrically connected to the electronic panel EP and the driving circuit IC. The main circuit board may include various driving circuits for operating the electronic panel EP, a connector for power supply, and/or the like. The main circuit board may be a rigid printed circuit board (PCB), but may not be limited thereto and may be a flexible circuit board, and the present invention may not be limited to any one embodiment.

The electronic module 400 is disposed under the display module 300. The electronic module 400 may receive the external input transmitted via the first area A1 and/or the hole area AH or output a signal via the first area A1 and/or the hole area AH. According to one or more embodiments, the electronic module 400 may include infrared (IR) sensors 410 and 420 disposed in the hole area AH and a camera module 430 disposed in the first area A1. The IR sensors 410 and 420 may include one of a light emitting module LM and a light receiving module LRM, which will be described in FIG. 2B, and the camera module 430 may correspond to a camera module CMM, which will be described in FIG. 2B. According to the present invention, as the first area A1 and the hole area AH, which have relatively high transmittance, are provided within the active area AA, the electronic module 400 may be disposed overlapping the active area AA. Accordingly, an increase in the bezel area BZA may be prevented.

Referring to FIG. 2B, the electronic device 1000 may include the display module 300, a power supply module PM, a first electronic module EM1, and a second electronic module EM2. The display module 300, the power supply module PM, the first electronic module EM1, and the second electronic module EM2 may be electrically connected to each other. In FIG. 2B, the display panel DP and an input sensor ISL from among the components of the display module 300 are shown as examples.

The power supply module PM supplies power required for overall operation of the electronic device 1000. The power supply module PM may include a conventional battery module.

The first electronic module EM1 and the second electronic module EM2 include various functional modules for operating the electronic device 1000. The first electronic module EM1 may be mounted directly on a motherboard electrically connected to the electronic panel EP, or may be mounted on a separate board and electrically connected to the motherboard via a connector.

The first electronic module EM1 may include a control module CM, a wireless communication module TM, an image input module IIM, an audio input module AIM, a memory MM, and an external interface IF. Some of the modules may not be mounted on the motherboard, and may be electrically connected to the motherboard via a flexible printed circuit board.

The control module CM controls the overall operation of the electronic device 1000. The control module CM may be a microprocessor. For example, the control module CM activates or deactivates the display module 300. The control module CM may control other modules such as the image input module IIM and/or the audio input module AIM based on a touch signal received from the electronic panel EP.

The wireless communication module TM may transmit/receive a wireless signal to and/or from another terminal using Bluetooth and/or Wi-Fi. The wireless communication module TM may transmit and/or receive a voice signal using a general communication line. The wireless communication module TM includes a transmitter TM1 that modulates a signal to be transmitted and transmits the modulated signal, and a receiver TM2 that demodulates a received signal.

The image input module IIM processes an image signal and converts the image signal into image data that may be displayed on the electronic panel EP. The audio input module AIM receives an external acoustic signal via a microphone in a recording mode, a voice recognition mode, and/or the like and converts the acoustic signal into electrical voice data.

The external interface IF serves as an interface connected to an external charger, a wired and/or wireless data port, a card (e.g., a memory card and a SIM/UIM card) socket, and/or the like.

The second electronic module EM2 may include an audio output module AOM, the light emitting module LM, the light receiving module LRM, the camera module CMM, and/or the like. In one or more embodiments, one or more of the components of the second electronic module EM2 may be located externally to the second electronic module EM2 and electrically connected thereto. The above components may be mounted directly on the motherboard, mounted on a separate board and electrically connected to the electronic panel EP via a connector, or electrically connected to the first electronic module EM1.

The audio output module AOM converts audio data received from the wireless communication module TM and/or the audio data stored in the memory MM and outputs the converted audio data to the outside.

The light emitting module LM generates and outputs light. The light emitting module LM may output an infrared ray. The light emitting module LM may include an LED element. The light receiving module LRM may sense the infrared ray. The light receiving module LRM may be activated when the infrared light with a level equal to or higher than a suitable level (e.g., a predetermined level) is sensed. The light receiving module LRM may include a CMOS sensor. After the infrared ray generated in the light emitting module LM is output, the infrared ray may be reflected by an external object (e.g., a user's finger or face), and the reflected infrared ray may be incident on the light receiving module LRM. The light emitting module LM and the light receiving module LRM may be defined as infrared ray sensors (IR sensors). The camera module CMM captures an external image.

The electronic module 400 according to one or more embodiments of the present invention may include at least one of the components of the second electronic module EM2. For example, the electronic module 400 may include at least one of the IR sensor, the camera module CMM, a speaker, a light detection sensor, and/or a heat detection sensor.

According to the present invention, the camera module CMM may overlap the first area A1, and the at least one IR sensor may overlap the hole area AH.

The electronic module 400 may sense an external input received via the first area A1 and/or the hole area AH, and/or provide a sound signal such as voice to the outside via the first area A1 and/or the hole area AH. Additionally, the electronic module 400 may include a plurality of components and the present invention may not be limited to any one embodiment. In one or more embodiments, the electronic module 400 may be attached to the electronic panel EP using a separate adhesive.

Again, referring to FIG. 2A, the housing 200 is combined with the window 100. The housing 200 is combined with the window 100 and provides a suitable internal space (e.g., a predetermined internal space). The display module 300 and the electronic module 400 may be accommodated in the internal space.

The housing 200 may contain a material with relatively high rigidity. For example, the housing 200 may contain a plurality of frames and/or plates containing or made of glass, plastic, and/or metal, and/or a combination thereof. The housing 200 may stably protect the components of the electronic device 1000 accommodated in the internal space from an external impact.

Referring to FIG. 3A, the display panel DP may include a timing controller TC, a scan driving circuit SDC, and a data driving circuit DDC. At least one of the timing controller TC, the scan driving circuit SDC, and the data driving circuit DDC may be provided in a form of a driving chip or may be formed directly in the display panel DP.

The timing controller TC may receive input image signals, convert a data format of the input image signals to meet interface specifications with the scan driving circuit SDC, and generate image data D-RGB. The timing controller TC outputs the image data D-RGB and various control signals DCS and SCS.

The scan driving circuit SDC may receive the scan control signal SCS from the timing controller TC. The scan control signal SCS may include a vertical start signal that initiates an operation of the scan driving circuit SDC, a clock signal that determines output timings of signals, and/or the like. The scan driving circuit SDC may generate a plurality of scan signals and sequentially output the scan signals to corresponding signal lines SL1 to SLn, GL1 to GLn, and HL1 to HLn. Additionally, the scan driving circuit SDC may generate a plurality of light emission control signals in response to the scan control signal SCS and output the light emission control signals to corresponding light emission lines EL1 to ELn.

Although it is shown in FIG. 3A that the plurality of scan signals and the plurality of light emission control signals are output from the one scan driving circuit SDC, the present invention is not limited thereto. For example, a plurality of scan driving circuits may be provided. The plurality of scan driving circuits may generate and then output the scan signals in a divided manner, and may generate and then output the plurality of light emission control signals in a divided manner. Additionally, a driving circuit that generates and outputs the plurality of scan signals and a driving circuit that generates and outputs the plurality of light emission control signals may be separated from each other.

The data driving circuit DDC may receive the data control signal DCS and the image data D-RGB from the timing controller TC. The data driving circuit DDC may convert the image data D-RGB into data signals and output the data signals to a plurality of data lines DL1 to DLm, which will be described later. The data signals may be analog voltages corresponding to grayscale values of the image data D-RGB.

The display panel DP may include a plurality of groups of signal lines. When one of the plurality of groups of signal lines is defined as a first signal line, another one may be defined as a second signal line, and still another one may be defined as a third signal line. Hereinafter, names of the signal lines are defined to distinguish the plurality of groups of signal lines from each other.

The plurality of groups of signal lines may include the first group of scan lines SL1 to SLn, the second group of scan lines GL1 to GLn, the third group of scan lines HL1 to HLn, the light emission lines EL1 to ELn, the data lines DL1 to DLm, a first voltage line PL, a second voltage line VL1, and a third voltage line VL2. The first group of scan lines SL1 to SLn, the second group of scan lines GL1 to GLn, the third group of scan lines HL1 to HLn, and the light emission lines EL1 to ELn may extend in the second direction DR2 and may be arranged along the first direction DR1, which crosses the second direction DR2. The plurality of data lines DL1 to DLm may extend along the first direction DR1 and may be spaced from each other along the second direction DR2 to cross the first group of scan lines SL1 to SLn, the second group of scan lines GL1 to GLn, the third group of scan lines HL1 to HLn, and the light emission lines EL1 to ELn in an insulated manner. According to one or more embodiments, the data lines DL1 to DLm overlapping the first area A1 may contain a different material for each area to improve the optical transmittance in the first area A1. A description thereof will be made later.

Each of the first voltage line PL, the second voltage line VL1, and the third voltage line VL2 may include at least one of a component extending in the first direction DR1 and a component extending in the second direction DR2. Structures and shapes of the first voltage line PL, the second voltage line VL1, and the third voltage line VL2 may be designed independently of each other.

Each of the plurality of pixels PXij may be electrically connected to corresponding signal lines from among the above-described signal lines. Depending on a configuration of a driving circuit of the pixels PXij, a connection relationship between the pixels PXij and the signal lines may change.

The first voltage line PL may receive a first power voltage ELVDD. A second power voltage ELVSS may be applied to the display panel DP. The second power voltage ELVSS may have a lower level than the first power voltage ELVDD.

The second voltage line VL1 may receive a first initialization voltage Vint. The first initialization voltage Vint may have a lower level than the first power voltage ELVDD. The third voltage line VL2 may receive a second initialization voltage VAint. The second initialization voltage VAint may have a lower level than the first power voltage ELVDD. The first initialization voltage Vint and the second initialization voltage VAint may be bias voltages having a constant level. The first initialization voltage Vint and the second initialization voltage VAint may have different levels. The second initialization voltage VAint may have a lower level than the first initialization voltage Vint.

The plurality of pixels PXij may include a plurality of groups that generate light of different colors. The plurality of pixels PXij may be also called as a plurality of groups of pixels PXij or a group of pixels PXij. For example, the plurality of pixels PXij may include red pixels generating red light, green pixels generating green light, and blue pixels generating blue light. A light emitting element of the red pixel, a light emitting element of the green pixel, and a light emitting element of the blue pixel may include light emitting layers made of different materials.

FIG. 3B is an equivalent circuit diagram of the one pixel PXij included in the display panel DP. The pixel PXij shown in FIG. 3B may be commonly applied to the pixels arranged in the active area AA. The pixel PXij may include a pixel circuit PC including transistors and conductive patterns, and a light emitting element OLED connected to the pixel circuit PC.

In FIG. 3B, the pixel PXij that is connected to the i-th scan line SLi of the first group from among the first group of scan lines SL1 to SLn and connected to the j-th data line DLj from among the plurality of data lines DL1 to DLm is shown as an example. The pixel PXij may include the pixel driving circuit (hereinafter, referred to as a pixel circuit) PC and the light emitting element OLED.

In one or more embodiments, the pixel circuit PC may include first to seventh transistors T1 to T7 and a capacitor Cst. The first transistor T1, the second transistor T2, and the fifth to seventh transistors T5 to T7 may be P-type transistors, and the third transistor T3 and the fourth transistor T4 may be N-type transistors. However, the present invention may not be limited thereto, and the first to seventh transistors T1 to T7 may be implemented as one of the P-type transistor and the N-type transistor.

Hereinafter, an input area (or an input electrode) of the N-type transistor is described as a drain (or a drain area), an input area of the P-type transistor is described as a source (or a source area), an output area of the N-type transistor (or an output electrode) is described as a source (or a source area), and an output area of the P-type transistor is described as a drain (or a drain area). In one example, at least one of the first to seventh transistors T1 to T7 may be omitted.

The first transistor T1 may be a driving transistor, and the second transistor T2 may be a switching transistor. The capacitor Cst may be electrically connected to and disposed between the first voltage line PL that receives the first power voltage ELVDD and a reference node RN. The capacitor Cst may include a first electrode CE10 electrically connected to the reference node RN and a second electrode CE20 electrically connected to the first voltage line PL.

The first transistor T1 may be electrically connected to and disposed between the first voltage line PL and one electrode (e.g., an anode) of the light emitting element OLED. A source S1 of the first transistor T1 may be electrically connected to the first voltage line PL. Herein, "electrically connected to and disposed between a transistor and a signal line or between a transistor and a transistor" means "a source, a drain, and a gate of the transistor have an integral shape with the signal line, or are connected thereto via a connection electrode". Another transistor may be disposed between the source S1 of the first transistor T1 and the first voltage line PL or may be omitted.

A drain D1 of the first transistor T1 may be electrically connected to the anode of the light emitting element OLED. Another transistor may be disposed between the drain D1 of the first transistor T1 and the anode of the light emitting element OLED, or may be omitted. A gate G1 of the first transistor T1 may be electrically connected to the reference node RN.

The second transistor T2 may be electrically connected to and disposed between the j-th data line DLj and the source S1 of the first transistor T1. A source S2 of the second transistor T2 is electrically connected to the j-th data line DLj, and a drain D2 of the second transistor T2 is electrically connected to the source S1 of the first transistor T1. A gate G2 of the second transistor T2 may be electrically connected to the i-th scan line SLi of the first group.

The third transistor T3 may be electrically connected to and disposed between the reference node RN and the drain D1 of the first transistor T1. A drain D3 of the third transistor T3 may be electrically connected to the drain D1 of the first transistor T1, and a source S3 of the third transistor T3 may be electrically connected to the reference node RN. Gates G3-1 and G3-2 of the third transistor T3 may be electrically connected to the i-th scan line GLi of the second group. Although it is shown that the third transistor T3 includes the plurality of gates, the present invention may not be limited thereto, and the third transistor T3 may include only one gate.

The fourth transistor T4 may be electrically connected to and disposed between the reference node RN and the second voltage line VL1. A drain D4 of the fourth transistor T4 may be electrically connected to the reference node RN, and a source S4 of the fourth transistor T4 may be electrically connected to the second voltage line VL1. Gates G4-1 and G4-2 of the fourth transistor T4 may be electrically connected to the i-th scan line HLi of the third group. Although the fourth transistor T4 including the plurality of gates is shown, the present invention may not be limited thereto, and the fourth transistor T4 may include only one gate.

The fifth transistor T5 may be electrically connected to and disposed between the first voltage line PL and the source S1 of the first transistor T1. A source S5 of the fifth transistor T5 may be electrically connected to the first voltage line PL, and a drain D5 of the fifth transistor T5 may be electrically connected to the source S1 of the first transistor T1. A gate G5 of the fifth transistor T5 may be electrically connected to the i-th light emission line ELi.

The sixth transistor T6 may be electrically connected to and disposed between the drain D1 of the first transistor T1 and the light emitting element OLED. A source S6 of the sixth transistor T6 may be electrically connected to the drain D1 of the first transistor T1, and a drain D6 of the sixth transistor T6 may be electrically connected to the anode of the light emitting element OLED. A gate G6 of the sixth transistor T6 may be electrically connected to the i-th light emission line ELi. Alternatively, the gate G6 of the sixth transistor T6 may be connected to a signal line different from that of the gate G5 of the fifth transistor T5.

The seventh transistor T7 may be electrically connected to and disposed between the drain D6 of the sixth transistor T6 and the third voltage line VL2. A source S7 of the seventh transistor T7 is electrically connected to the drain D6 of the sixth transistor T6, and a drain D7 of the seventh transistor T7 is electrically connected to the third voltage line VL2. A gate G7 of the seventh transistor T7 may be electrically connected to the i+1-th scan line SLi+1 of the first group.

According to one or more embodiments, semiconductor patterns included in the first, second, fifth to seventh transistors T1, T2, and T5 to T7 may include a silicon semiconductor, and semiconductor patterns included in the third and fourth transistors T3 and T4 may include an oxide semiconductor. However, the present invention may not be limited thereto, and the semiconductor patterns included in the first to seventh transistors T1 to T7 may include only one selected from among the group of the silicon semiconductor and the oxide semiconductor.

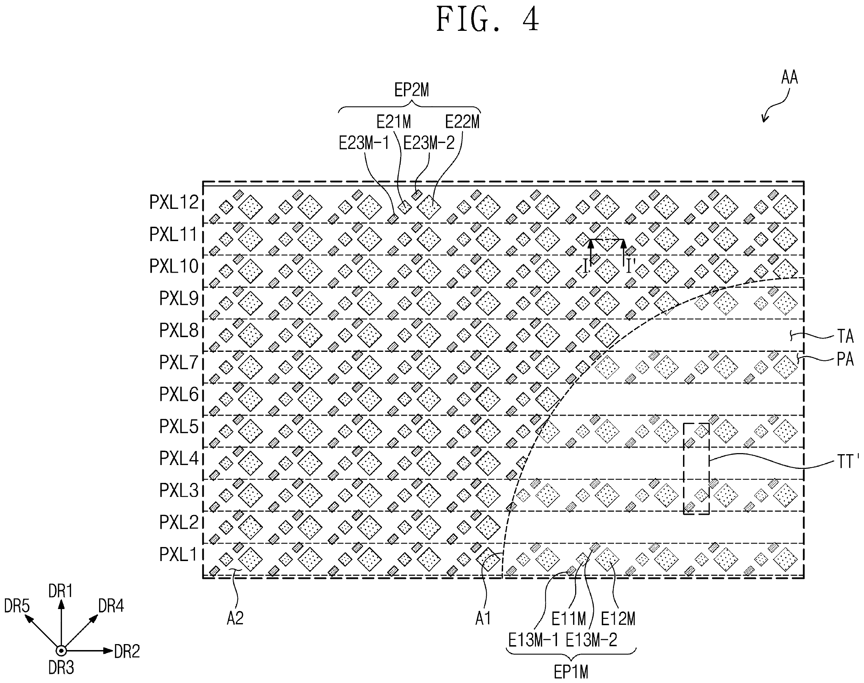

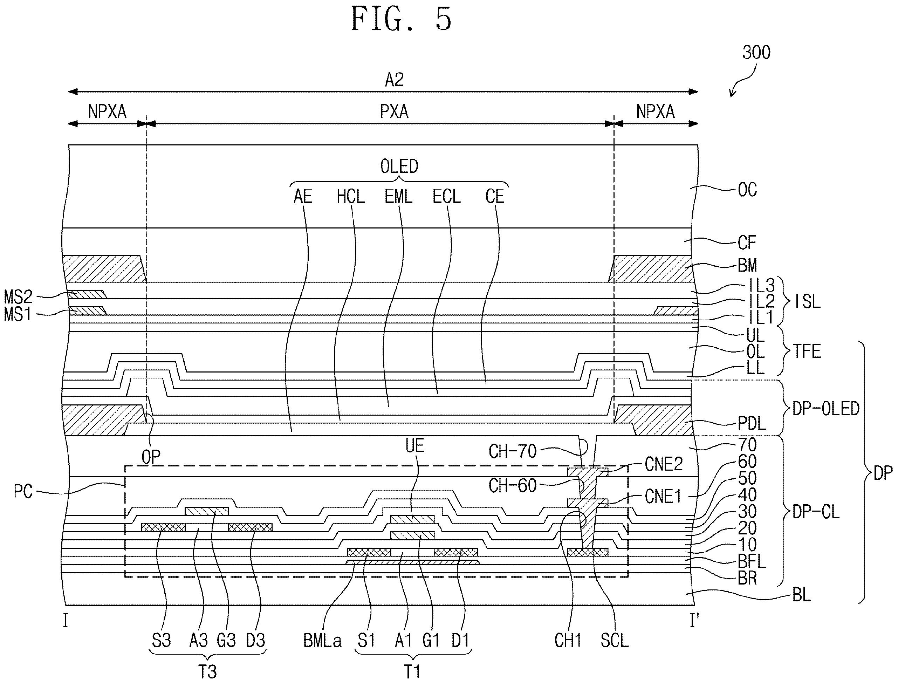

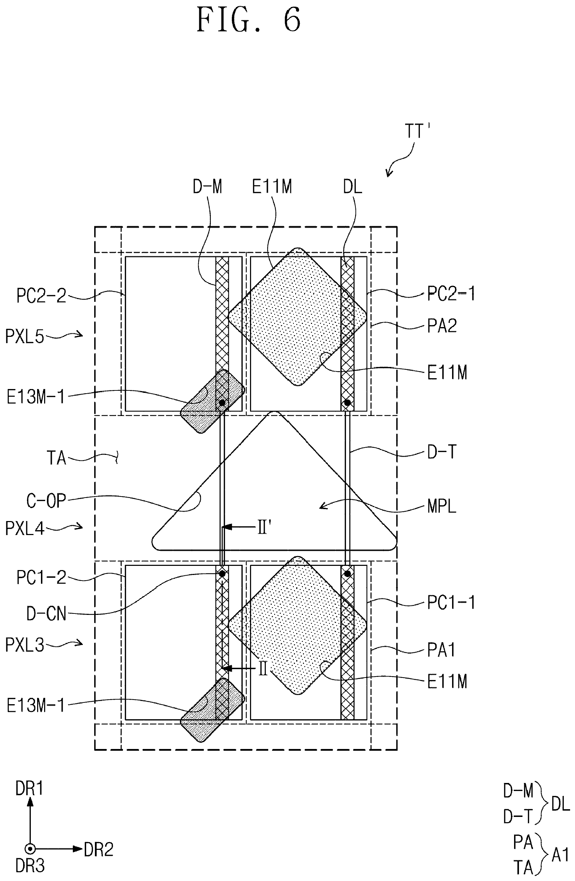

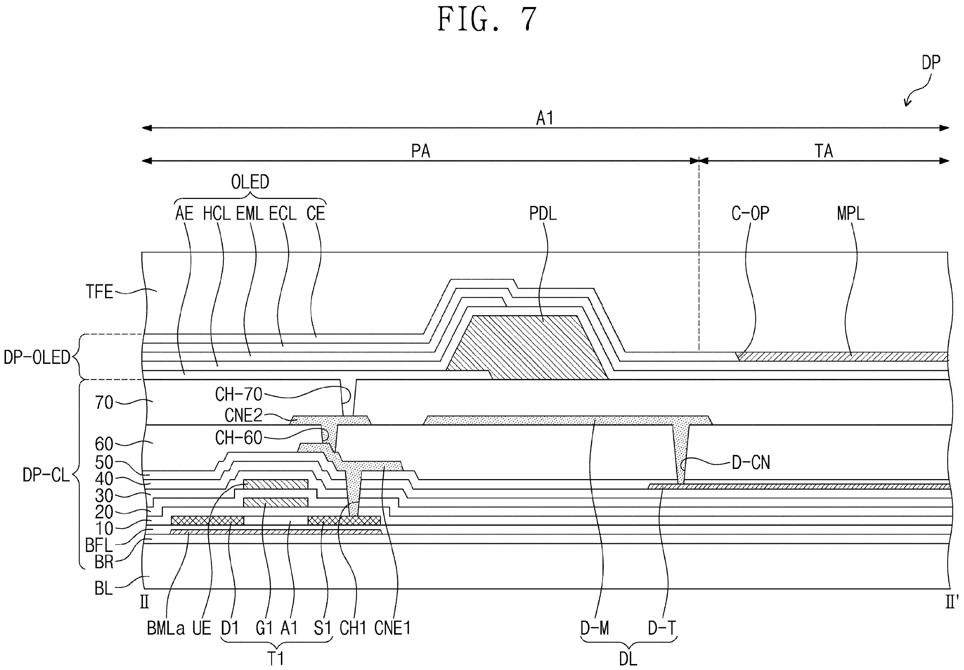

FIG. 4 is a plan view of an active area according to one or more embodiments of the present invention. FIG. 5 is a cross-sectional view taken along the line I-I' in FIG. 4. FIG. 6 is an enlarged plan view of an area TT' in FIG. 4. FIG. 7 is a cross-sectional view of a display panel taken along the line II-II' in FIG. 6 according to one or more embodiments of the present invention. FIG. 4 illustrates 12 pixel rows PXL1 to PLX12 arranged in the active area AA.

For convenience of description, one pixel is shown in FIG. 4 in a shape on a plane of a light emitting area PXA to be described in FIG. 5, but substantially, the one pixel will include the pixel circuit PC and the light emitting element OLED as described in FIG. 3B.

Referring to FIG. 4, the display module 300 according to the present invention may include the plurality of pixels arranged in the active area AA. Pixels may be grouped for each area in which they are arranged. According to the present embodiment, pixels arranged in the first area A1 may be defined as 'first pixel groups', and pixels arranged in the second area A2 may be defined as 'second pixel groups'. The first area A1 may include circuit areas PA where the pixel circuits PC (e.g., see FIG. 3B) included in the pixels included in the first pixel groups are arranged and transmissive areas TA. The pixel circuits PC (e.g., see FIG. 3B) in the first group of pixels in the circuit areas PA may be spaced from the transmissive areas TA.

The first pixel groups may be spaced from each other along the first direction DR1 within the first area A1, and may extend along the second direction DR2. According to the present invention, two first pixel groups adjacent to each other along the first direction DR1 may be spaced from each other with the transmissive area TA interposed therebetween.

One first pixel group may have a structure in which first pixel units EP1M are regularly arranged along the second direction DR2. The first pixel units EP1M may include first to third-second sub-pixels E11M, E12M, E13M-1, and E13M-2 that provide different light. The first pixel units EP1M may be also called as first unit pixels or unit pixels. The first to third-second sub-pixels E11M, E12M, E13M-1, and E13M-2 may be also called as first to third-second pixels. Furthermore, a third-first sub-pixel and a first-second sub-pixel may be called as third-first pixel and a first-second pixel.

The first sub-pixel E11M, also called as first pixel, may be spaced from the second sub-pixel E12M, also called as second pixel, along the second direction DR2. Area sizes of light emitting areas where light is provided in the first sub-pixel E11M and the second sub-pixel E12M may be different from each other. The light emitting area of the first sub-pixel E11M may have a smaller area size than the light emitting area of the second sub-pixel E12M. According to one or more embodiments, the light emitting area of the first sub-pixel E11M and the light emitting area of the second sub-pixel E12M may have a diamond shape on a plane. The first sub-pixel E11M may provide red light, and the second sub-pixel E12M may provide blue light.

The third-first sub-pixel E13M-1 and the third-second sub-pixel E13M-2 may be spaced from each other along a diagonal direction intersecting the first direction DR1 and the second direction DR2 (i.e., a fourth direction DR4) with the first sub-pixel E11M interposed therebetween. A light emitting area of each of the third-first sub-pixel E13M-1 and the third-second sub-pixel E13M-2, also called as third-second pixel, may have a rectangular shape extending in the fourth direction DR4. An area size of the light emitting areas of the third-first sub-pixel E13M-1, also called as third-first, pixel, and the third-second sub-pixel E13M-2 may be smaller than the area size of the light emitting area of the first sub-pixel E11M. The third-first sub-pixel E13M-1 and the third-second sub-pixel E13M-2 may provide green light.

The second pixel groups may be spaced from each other along the first direction DR1 within the second area A2, and may extend along the second direction DR2.

One second pixel group may have a structure in which second pixel units EP2M are regularly arranged along the second direction DR2. The second pixel units EP2M may include first to third-second sub-pixels E21M, E22M, E23M-1, and E23M-2 that provide different color lights.

The first sub-pixel E21M may be spaced from the second sub-pixel E22M along the second direction DR2. Area sizes of light emitting areas where light is provided in the first sub-pixel E21M and the second sub-pixel E22M may be different from each other. The light emitting area of the first sub-pixel E21M may have a smaller area size than the light emitting area of the second sub-pixel E22M. According to one or more embodiments, the light emitting area of the first sub-pixel E21M and the light emitting area of the second sub-pixel E22M may have a diamond shape on a plane. The first sub-pixel E21M may provide red light, and the second sub-pixel E22M may provide blue light.

The third-first sub-pixel E23M-1 and the third-second sub-pixel E23M-2 may be spaced from each other along the fourth direction DR4 with the first sub-pixel E21M interposed therebetween. A light emitting area of each of the third-first sub-pixel E23M-1 and the third-second sub-pixel E23M-2 may have a rectangular shape extending in the fourth direction DR4. An area size of the light emitting areas of the third-first sub-pixel E23M-1 and the third-second sub-pixel E23M-2 may be smaller than the area size of the light emitting area of the first sub-pixel E21M. The third-first sub-pixel E23M-1 and the third-second sub-pixel E23M-2 may provide green light.

According to the present invention, the sub-pixels included in the one first pixel unit EP1M and the sub-pixels included in the one second pixel unit EP2M may have the same arrangement form. However, the present invention may not be limited thereto, area sizes of light emitting areas of sub-pixels included in different pixel units and providing light of the same color may be different from each other, and the arrangement forms of the sub-pixels included in the one first pixel unit EP1M and the sub-pixels included in the one second pixel unit EP2M may be different from each other.

According to the present embodiment, the second pixel groups may be included in all of the first to twelfth pixel rows PXL1 to PXL12. The first pixel groups may be disposed only in the first, third, fifth, seventh, and ninth pixel rows PXL1, PXL3, PXL5, PXL7, and PXL9, and the first pixel groups may not be disposed in the second, fourth, sixth, and eighth pixel rows PXL2, PXL4, PXL6, and PXL8.

More specifically, the pixel circuits PC (e.g., see FIG. 3B) of sub-pixels arranged in the first, third, fifth, seventh, and ninth pixel rows PXL1, PXL3, PXL5, PXL7, and PXL9 may be disposed only in the circuit areas PA, and may not be disposed in the transmissive areas TA. Some of the pixel circuits PC (e.g., see FIG. 3B) in the second group of pixels may be aligned with the transmissive areas TA along the second direction DR2.

Within the same area size, the number of sub-pixels arranged in the second area A2 may be greater than the number of sub-pixels arranged in the first area A1. In addition, as the first area A1 includes the transmissive areas TA where the pixel circuits PC (e.g., see FIG. 3B) included in the sub-pixels are not arranged, the transmittance of the first area A1 may be relatively higher than that of the second area A2. Accordingly, a performance of the camera module 430 (e.g., see FIG. 2A) disposed under the first area A1 may be prevented from being deteriorated. However, a problem that portions overlapping the transmissive areas TA of signal lines extending in the first direction DR1, for example, the data lines DL1 to DLm, contain a metal material, and accordingly affect the camera module 430 (e.g., see FIG. 2A) may be required to be ameliorated.

FIG. 5 shows a cross-sectional view of the display module 300 overlapping the second area A2. FIG. 5 shows a cross-section of a portion corresponding to the first transistor T1 and the third transistor T3 from among the first to seventh transistors T1 to T7 described in FIG. 3B.

The display module 300 may include the display panel DP, the input sensor ISL, a black matrix BM, a color filter CF, and an overcoat layer OC.

The display panel DP may include a base layer BL, a circuit element layer DP-CL, a display element layer DP-OLED, and a thin film encapsulation layer TFE. The first area A1, the hole area AH, and the second area A2 described in FIG. 2A may be described as being defined in the base layer BL.

The display panel DP may further include functional layers such as an antireflection layer and/or a refractive index adjustment layer. The circuit element layer DP-CL includes at least a plurality of insulating layers and a circuit element. Hereinafter, the insulating layers may include an organic layer and/or an inorganic layer.

The insulating layer, a semiconductor layer, and a conductive layer are formed via coating, deposition, and the like. Thereafter, the insulating layer, the semiconductor layer, and the conductive layer may be selectively patterned using photolithography. In such scheme, the semiconductor pattern, the conductive pattern, the signal line, and the like are formed.

The base layer BL may be a base layer on which components included in the circuit element layer DP-CL are disposed. The base layer BL may have a structure in which a layer containing an organic material and a layer containing an inorganic material are alternately stacked. For example, in the present embodiment, the base layer BL may include a first base layer containing an organic material, a first barrier layer containing an inorganic material and covering the first base layer, a second base layer containing an organic material and disposed on the first barrier layer, and a second barrier layer containing an inorganic material and covering the second base layer.

The organic materials contained in the first base layer and the second base layer may include at least one of polyimide (PI), polyethylene naphthalate (PEN), polyethylene terephthalate (PET), polyarylate, polycarbonate (PC), polyetherimide (PEI), and/or polyethersulfone (PES).

The inorganic materials contained in the first barrier layer and the second barrier layer may include at least one of silicon oxide, silicon oxynitride, aluminum oxide, titanium oxide, silicon nitride, zirconium oxide, and/or hafnium oxide.

However, the present invention may not be limited thereto, and the base layer BL may be provided as a single layer. In this regard, the base layer BL may include a synthetic resin layer. The synthetic resin layer may contain a thermosetting resin. In particular, the synthetic resin layer may be a polyimide-based resin layer, and a material thereof is not particularly limited. In addition, the base layer BL may contain glass, metal, and/or an organic/inorganic composite material.

A barrier layer BR may be disposed on the base layer BL. The barrier layer BR may prevent foreign substances from entering from the outside. The barrier layer BR may include at least one inorganic layer. For example, the barrier layer BR may include a silicon oxide layer and/or a silicon nitride layer. The silicon oxide layer and the silicon nitride layer may include a plurality of silicon oxide layers and a plurality of silicon nitride layers, respectively, and the silicon oxide layers and the silicon nitride layers may be alternately stacked.

A shielding electrode BMLa may be disposed on the barrier layer BR. The shielding electrode BMLa may contain metal. The shielding electrode BMLa may contain molybdenum (Mo), which has good heat resistance, an alloy containing molybdenum, titanium (Ti), and/or an alloy containing titanium. The shielding electrode BMLa may receive a bias voltage. The shielding electrode BMLa may receive the first power voltage ELVDD. The shielding electrode BMLa may block an electrical potential resulted from polarization from affecting a silicon semiconductor pattern. The shielding electrode BMLa may block external light from reaching the silicon semiconductor pattern. In one example, the shielding electrode BMLa may be a floating electrode that is isolated from another electrode or wiring.

A buffer layer BFL may be disposed on the barrier layer BR and the shielding electrode BMLa. The buffer layer BFL may prevent or reduce diffusion of metal atoms or impurities from the base layer BL to the silicon semiconductor pattern disposed above. The buffer layer BFL may include at least one of silicon oxide and/or silicon nitride. Additionally, the buffer layer BFL may include a silicon oxynitride layer having a single-layer or multi-layer structure, and the present invention may not be limited to any one embodiment.

The silicon semiconductor pattern of the first transistor T1 is disposed on the buffer layer BFL. Hereinafter, a silicon semiconductor pattern directly disposed on the buffer layer BFL is defined as a first semiconductor pattern. The first semiconductor pattern may contain polysilicon. However, without being limited thereto, the first semiconductor pattern may contain amorphous silicon.

FIG. 5 shows only a portion of the first semiconductor pattern. The first semiconductor pattern may further be disposed in another area of the pixel PXij (e.g., see FIG. 3B). The first semiconductor pattern has different electrical properties depending on whether it is doped. The first semiconductor pattern may include a doped area and an un-doped area. The doped area may be doped with an N-type dopant or a P-type dopant. The P-type transistor includes a doped area doped with the P-type dopant.

The source S1, an active A1 (hereinafter, also be referred to as a channel area), and the drain D1 of the first transistor T1 are formed from the first semiconductor pattern. The source S1 and the drain D1 of the first transistor T1 are formed to be spaced from each other with the active A1 interposed therebetween.

A connection signal line SCL may be disposed on the buffer layer BFL. The connection signal line SCL may be connected to the drain D6 (e.g., see FIG. 3B) of the sixth transistor T6 (e.g., see FIG. 3B).

A first insulating layer 10 may be disposed on the buffer layer BFL and covers the first semiconductor pattern and the connection signal line SCL. In the present embodiment, the first insulating layer 10 may be a silicon oxide layer of a single-layer structure. The first insulating layer 10 as well as the insulating layer of the circuit element layer DP-CL described later may be an inorganic layer and/or an organic layer and may have a single-layer or multi-layer structure. The inorganic layer may contain at least one of the materials described above.

The gate G1 of the first transistor T1 is disposed on the first insulating layer 10. The gate G1 may be a portion of a metal pattern. The gate G1 of the first transistor T1 overlaps the active A1 of the first transistor T1 in a thickness direction of the base layer BL (e.g., the third direction DR3). In the process of doping the first semiconductor pattern, the gate G1 of the first transistor T1 is like a mask.

A second insulating layer 20 that covers the gate G1 may be disposed on the first insulating layer 10. The second insulating layer 20 may be an inorganic layer and/or an organic layer, and may have a single-layer or multi-layer structure. In the present embodiment, the second insulating layer 20 may be the inorganic layer and/or the organic layer, and may have the single-layer or multi-layer structure. In the present embodiment, the second insulating layer 20 may be a silicon nitride layer of the single-layer structure.

An upper electrode UE may be disposed on the second insulating layer 20. The upper electrode UE may overlap the gate G1 in the thickness direction of the base layer BL (e.g., the third direction DR3). The upper electrode UE may be a portion of a metal pattern or a doped semiconductor pattern. A portion of the gate G1 and the upper electrode UE overlapping therewith may define the capacitor Cst (e.g., see FIG. 3B). In one or more embodiments of the present invention, the upper electrode UE may be omitted.

In one or more embodiments of the present invention, the second insulating layer 20 may be replaced with an insulating pattern. The upper electrode UE is disposed on the insulating pattern. The upper electrode UE may serve as a mask to form the insulating pattern from the second insulating layer 20.

In one or more embodiments, the first electrode CE10 and the second electrode CE20 of the capacitor Cst (e.g., see FIG. 3B) may be formed via the same process as the gate G1 and the upper electrode UE. The first electrode CE10 may be disposed on the first insulating layer 10. The first electrode CE10 may have an integral shape with the gate G1.

A third insulating layer 30 that covers the upper electrode UE is disposed on the second insulating layer 20. In the present embodiment, the third insulating layer 30 may include a plurality of silicon oxide layers and silicon nitride layers alternately stacked. In one or more embodiments, the sources S2, S5, S6, and S7 (e.g., see FIG. 3B), the drains D2, D5, D6, and D7 (e.g., see FIG. 3B), and the gates G2, G5, G6, and G7 (e.g., see FIG. 3B) of the second, fifth, sixth, and seventh transistors T2, T5, T6, and T7 (e.g., see FIG. 3B) may be formed via the same processes as the source S1, the drain D1, and the gate G1 of the first transistor T1.

An oxide semiconductor pattern is disposed on the third insulating layer 30. Hereinafter, a semiconductor pattern directly disposed on the third insulating layer 30 is defined as a second semiconductor pattern. The second semiconductor pattern may contain metal oxide. An oxide semiconductor may contain a crystalline or amorphous oxide semiconductor.

For example, the oxide semiconductor may contain a metal oxide such as zinc (Zn), indium (In), gallium (Ga), tin (Sn), and/or titanium (Ti), and/or a mixture of metal such as zinc (Zn), indium (In), gallium (Ga), tin (Sn), and/or titanium (Ti), and/or an oxide thereof. The oxide semiconductor may include indium-tin oxide (ITO), indiumgallium-zinc oxide (IGZO), zinc oxide (ZnO), indium-zinc oxide (IZnO), zinc-indium oxide (ZIO), indium oxide (InO), and/or titanium oxide (TiO), indium-zinc-tin oxide (IZTO), zinc-tin oxide (ZTO), and/or the like.

As shown in FIG. 5, the source S3, the active A3 (hereinafter, also be referred to as a channel area), and the drain D3 of the third transistor T3 are formed from the second semiconductor pattern. The source S3 and the drain D3 contain metal reduced from a metal oxide semiconductor. The source S3 and the drain D3 may have a suitable thickness (e.g., a predetermined thickness) from a top surface of the second semiconductor pattern, and may include a metal layer containing the reduced metal.

A fourth insulating layer 40 that covers the second semiconductor pattern is disposed on the third insulating layer 30. In the present embodiment, the fourth insulating layer 40 may be a silicon oxide layer of a single-layer structure. The gate G3 of the third transistor T3 is disposed on the fourth insulating layer 40. The gate G3 may be a portion of a metal pattern. The gate G3 of the third transistor T3 overlaps the active A3 of the third transistor T3 in the thickness direction of the base layer BL (e.g., the third direction DR3).

In one or more embodiments of the present invention, the fourth insulating layer 40 may be replaced by an insulating pattern. The gate G3 of the third transistor T3 is disposed on the insulating pattern. In the present embodiment, the gate G3 may have the same shape as the insulating pattern on the plane.

A fifth insulating layer 50 that covers the gate G3 is disposed on the fourth insulating layer 40. In the present embodiment, the fifth insulating layer 50 may include a silicon oxide layer and/or a silicon nitride layer. The fifth insulating layer 50 may include a plurality of silicon oxide layers and/or silicon nitride layers alternately stacked.

In one or more embodiments, the source S4 (e.g., see FIG. 3B), the drain D4 (e.g., see FIG. 3B), and the gate G4 (e.g., see FIG. 3B) of the fourth transistor T4 (e.g., see FIG. 3B) may be formed via the same processes as the source S3, the drain D3, and the gate G3 of the third transistor T3, respectively.

At least one more insulating layer is disposed on the fifth insulating layer 50. As in the present embodiment, a sixth insulating layer 60 and a seventh insulating layer 70 may be disposed on the fifth insulating layer 50. The sixth insulating layer 60 and the seventh insulating layer 70 may be organic layers and may have a single-layer or multi-layer structure. The sixth insulating layer 60 and the seventh insulating layer 70 may be a polyimide-based resin layer of a single-layer structure.

Without being limited thereto, the sixth insulating layer 60 and the seventh insulating layer 70 may contain at least one of acrylic resin, methacrylic resin, polyisoprene, vinyl-based resin, epoxy-based resin, urethane-based resin, cellulosebased resin, siloxane-based resin, polyamide-based resin, and/or perylene-based resin.

A first connection electrode CNE1 may be disposed on the fifth insulating layer 50. The first connection electrode CNE1 may be connected to the connection signal line (or connection electrode) SCL via a first contact hole CH1 extending through the first to fifth insulating layers 10 to 50.

A second connection electrode CNE2 may be disposed on the sixth insulating layer 60. The second connection electrode CNE2 is connected to the first connection electrode CNE1 via a second contact hole CH-60 extending through the sixth insulating layer 60.

The light emitting element OLED is disposed on the seventh insulating layer 70. A first electrode (anode) AE of the light emitting element OLED is disposed on the seventh insulating layer 70. A pixel defining layer PDL is disposed on the seventh insulating layer 70. The pixel defining layer PDL may have an opening OP defined therein that exposes at least a portion of the first electrode AE. In the present embodiment, the pixel defining layer PDL may contain a light absorbing material. For example, the pixel defining layer PDL may have a black color.

The pixel circuit PC including the first to seventh transistors T1 to T7 (e.g., see FIG. 3B) and the light emitting element OLED connected thereto may form the one second sub-pixel E22M (e.g., see FIG. 4). The descriptions of the pixel circuit PC and the light emitting element OLED included in the second sub-pixel E22M (e.g., see FIG. 4) may be commonly applied to the sub-pixels arranged in the first area A1 and the second area A2.

The opening OP of the pixel defining layer PDL may define the light emitting area PXA. For example, the plurality of pixels PXij (e.g., see FIG. 3B) may be arranged in a certain rule on a plane of the display panel DP. An area where light generated from the one pixel PXij is emitted via the opening OP of the pixel defining layer PDL may be defined as the light emitting area PXA. The light emitting areas PXA may be surrounded by a non-light emitting area NPXA.

The first electrode AE is disposed on the seventh insulating layer 70. The first electrode AE is connected to the second connection electrode CNE2 via a third contact hole CH-70 extending through the seventh insulating layer 70.

A hole control layer HCL may be commonly disposed in the light emitting area PXA and the non-light emitting area NPXA. A common layer, such as the hole control layer HCL, may be commonly formed across the plurality of pixels PXij. The hole control layer HCL may include a hole transport layer and a hole injection layer.

A light emitting layer EML is disposed on the hole control layer HCL. The light emitting layer EML may be disposed only in an area corresponding to the opening OP. The light emitting layer EML may be formed separately in each of the plurality of pixels PXij.

Although the patterned light emitting layer EML is shown as an example in the present embodiment, the light emitting layer EML may be commonly disposed in the plurality of pixels PXij. In this regard, the light emitting layer EML may generate white light or blue light. Additionally, the light emitting layer EML may have a multi-layer structure.

An electron control layer ECL is disposed on the light emitting layer EML. The electron control layer ECL may include an electron transport layer and an electron injection layer. A second electrode CE is disposed on the electron control layer ECL. The electron control layer ECL and the second electrode CE are commonly disposed in the plurality of pixels PXij. Therefore, the second electrode CE may have an integral shape as a common layer. The thin film encapsulation layer TFE is disposed on the second electrode CE. The thin film encapsulation layer TFE is commonly disposed in the plurality of pixels PXij. In the present embodiment, the thin film encapsulation layer TFE directly covers the second electrode CE.

The thin film encapsulation layer TFE may include a first inorganic layer LL, an organic layer OL, and a second inorganic layer UL. However, without being limited thereto, the thin film encapsulation layer TFE may further include a plurality of inorganic layers and organic layers.

The first inorganic layer LL may be in contact with the second electrode CE. The first inorganic layer LL may prevent external moisture or oxygen from penetrating into the light emitting layer EML. For example, the first inorganic layer LL may contain silicon nitride, silicon oxide, and/or a combination thereof. The first inorganic layer LL may be formed via a deposition process.

The organic layer OL may be disposed on the first inorganic layer LL and may be in contact with the first inorganic layer LL. The organic layer OL may provide a flat surface on the first inorganic layer LL. Curves formed on a top surface of the first inorganic layer LL, particles present on the first inorganic layer LL, and/or the like may be covered by the organic layer OL, so that an influence of a surface condition of the top surface of the first inorganic layer LL on components formed on the organic layer OL may be blocked. The organic layer OL may contain an organic material and may be formed via a solution process such as spin coating, slit coating, and/or inkjet process.

The second inorganic layer UL is disposed on the organic layer OL and covers the organic layer OL. The second inorganic layer UL may be stably formed on a relatively flat surface rather than on the first inorganic layer LL. The second inorganic layer UL seals moisture and/or the like released from the organic layer OL and prevents the moisture and/or the like from flowing to the outside. The second inorganic layer UL may contain silicon nitride, silicon oxide, and/or a combination thereof. The second inorganic layer UL may be formed via a deposition process.

The input sensor ISL may be formed directly on the thin film encapsulation layer TFE. The input sensor ISL may include a plurality of conductive patterns MS1 and MS2, and sensing insulating layers. The sensing insulating layers may include a first sensing insulating layer IL1, a second sensing insulating layer IL2, and a third sensing insulating layer IL3. Each of the first sensing insulating layer IL1, the second sensing insulating layer IL2, and the third sensing insulating layer IL3 may contain at least one of an inorganic material and/or an organic material.

The first sensing insulating layer IL1 is disposed on the thin film encapsulation layer TFE. The first conductive patterns MS1 may be disposed on the first sensing insulating layer IL1 and covered by the second sensing insulating layer IL2. The second conductive patterns MS2 may be disposed on the second sensing insulating layer IL2 and covered by the third sensing insulating layer IL3.

Each of the conductive patterns MS1 and MS2 has conductivity. Each of the conductive patterns MS1 and MS2 may be provided as a single layer or may be provided as a plurality of layers, and the present invention may not be limited to any one embodiment. At least one of the conductive patterns MS1 and MS2 according to the present invention may be provided as mesh lines on a plane.

The mesh lines constituting the conductive patterns MS1 and MS2 may be spaced from the light emitting layer EML on a plane. Therefore, even when the input sensor ISL is formed directly on the display panel DP, light generated from the pixels PXij (e.g., see FIG. 3B) of the display panel DP may be provided to the user without interference of the input sensor ISL.

The color filter CF may overlap the light emitting layer EML in the thickness direction of the base layer BL (e.g., the third direction DR3). The color filter CF may selectively transmit light corresponding to light provided from the light emitting layer EML therethrough. For example, when the light emitting layer EML provides blue light, the color filter CF may be a blue color filter that transmits blue light therethrough.

The color filter CF may contain a polymer photosensitive resin and a pigment or a dye. For example, the color filter CF that overlaps the light emitting layer EML providing blue light contains a blue pigment or dye, the color filter CF that overlaps the light emitting layer EML providing green light contains a green pigment or dye, and the color filter CF that overlaps the light emitting layer EML providing red light may include a red pigment or dye.

However, the present invention may not be limited thereto, and the color filter CF that overlaps the light emitting layer EML providing blue light may not contain the pigment or the dye. In this regard, the color filter CF may be transparent, and the color filter CF may be made of a transparent photosensitive resin.

The black matrix BM may be disposed between color filters that provide different light. The black matrix BM, as a pattern with a black color, may be a gridshaped matrix. The black matrix BM may contain a black coloring agent. The black coloring agent may include a black dye and/or a black pigment. The black coloring agent may contain a metal such as chromium and/or an oxide thereof, and/or carbon black.

The overcoat layer OC may be disposed on the color filter CF and the black matrix BM. The overcoat layer OC may be a layer that covers irregularities generated during formation of the color filter CF and the black matrix BM and provides a flat surface. That is, the overcoat layer OC may be a planarization layer. The window 100 described in FIG. 2A may be bonded, via an adhesive layer, onto the overcoat layer OC that provides the flat surface.

FIG. 6 is an enlarged view of the area TT' in FIG. 4. FIG. 6 shows a connection relationship between the sub-pixels E13M-1 and E11M arranged in the third pixel row PXL3 in the first area A1, the sub-pixels E13M-1 and E11M arranged in the fifth pixel row PXL5, and the data line DL.

According to the present embodiment, the first area A1 overlapping the camera module 430 (e.g., see FIG. 2A) may include the circuit areas PA and the transmissive areas TA. The transmissive area TA may be disposed between the two adjacent circuit areas PA along the first direction DR1.

Each of the sub-pixels E13M-1 and E11M may include the pixel circuit PC and the light emitting element OLED connected thereto described in FIG. 3B.

The first sub-pixel E11M disposed in the third pixel row PXL3 may include a first-first pixel circuit PC1-1, and the third-first sub-pixel E13M-1 may include a first-second pixel circuit PC1-2. The first-first pixel circuit PC1-1 and the first-second pixel circuit PC1-2 may be arranged in a first circuit area PA1.

The first sub-pixel E11M disposed in the fifth pixel row PXL5 may include a second-first pixel circuit PC2-1, and the third-first sub-pixel E13M-1 may include a second-second pixel circuit PC2-2. The second-first pixel circuit PC2-1 and the second-second pixel circuit PC2-2 may be arranged in a second circuit area PA2.

According to one or more embodiments, the first circuit area PA1 may be spaced from the second circuit area PA2 along the first direction DR1 with the transmissive area TA interposed therebetween. The transmissive area TA may be an area where the pixel circuits of the sub-pixels arranged in the first area A1 are not disposed.

According to the present embodiment, an electrode hole C-OP extending through the second electrode CE may be defined in the second electrode CE (e.g., see FIG. 5). The plurality of electrode holes C-OP may be provided and arranged to be spaced from each other along the second direction DR2 within the one transmissive area TA. A shape of the electrode hole C-OP on a plane may be triangular. However, the present invention may not be limited thereto, and the shape of the electrode hole C-OP may have one of a circular shape or a polygonal shape.

The display module 300 according to one or more embodiments may further include a coating pattern MPL disposed inside the electrode hole C-OP. The coating pattern MPL may be provided to correspond to the number and the shape of the electrode holes C-OP. The coating pattern MPL may be transparent and may contain an organic material. The coating pattern MPL may be formed via a deposition process using a fine metal mask (FMM) mask. According to one or more embodiments, a portion of a first pattern D-T may overlap the coating pattern MPL.

According to the present invention, the optical transmittance of the first area A1 may be improved by defining the electrode hole C-OP in the second electrode CE (e.g., see FIG. 5) that overlaps the transmissive area TA.

The first sub-pixels E11M arranged in the first direction DR1 may be connected to the at least one data line DL, and the third-first sub-pixels E13M-1 arranged in the first direction DR1 may be connected to the at least one data line DL. Each of the data lines DL may extend along the first direction DR1 and may be connected to the pixel circuits arranged along the first direction DR1.

The data line DL may include the first patterns D-T and second patterns D-M alternately arranged along the first direction DR1. The first patterns D-T may overlap the transmissive areas TA, and the second patterns D-M may overlap the circuit areas PA.

More specifically, a portion of the one first pattern D-T may be included in different pixel columns and disposed between the circuit areas arranged along the first direction DR1. The remaining portion of the first pattern D-T may be disposed in the circuit areas PA to be connected to the second pattern D-M.

For example, one end of the first pattern D-T may be connected to the second pattern D-M disposed in the first-first pixel circuit PC1-1, and the other end of the first pattern D-T may be connected to the second pattern D-M disposed in the second-first pixel circuit PC2-1.

According to the present invention, the data line DL overlapping the first area A1 may contain a different material for each area. The first patterns D-T may contain transparent conductive oxides, and the second patterns D-M may contain metals. For example, each of the second patterns D-M may include sequentially stacked first to third layers. The first and third layers may contain titanium (Ti), and the second layer may contain aluminum (Al). A thickness of the second layer may be greater than thicknesses of the first layer and the third layer. According to the present invention, as the portion of the data line DL that overlaps the transmissive area TA contains the transparent conductive oxide, the optical transmittance of the first area A1 may be improved.

Referring to FIG. 7, the display panel DP overlapping the first area A1 according to one or more embodiments may include the circuit element layer DP-CL, the display element layer DP-OLED, and the thin film encapsulation layer TFE. Descriptions redundant with respect to the description of FIG. 5 will be omitted.

According to the present embodiment, the data line DL may include the first pattern D-T and the second pattern D-M. The first pattern D-T may be disposed on the fourth insulating layer (hereinafter, lower insulating layer) 40, and the first connection electrode CNE1 may be disposed on the fifth insulating layer (hereinafter, intermediate insulating layer) 50. The second pattern D-M may be disposed on the sixth insulating layer (hereinafter, upper insulating layer) 60. The second pattern D-M may contain the same material as the second connection electrode CNE2 and may be formed via the same process as the second connection electrode CNE2.

A portion of the first pattern D-T may be disposed in the transmissive area TA, and the remaining portion of the first pattern D-T may be disposed in the circuit area PA and overlap the second pattern D-M in the third direction DR3. The second pattern D-M may only be disposed in the circuit area PA. The first pattern D-T may contain the transparent conductive oxide, and the second pattern D-M may contain metal. According to the present embodiment, the second pattern D-M may be connected to the first pattern D-T via a contact hole D-CN defined in the intermediate insulating layer 50 and the upper insulating layer 60.

According to the present invention, as the portion overlapping the transmissive area TA of the data line DL disposed in the first area A1 overlapping the camera module 430 or CMM (e.g., see FIGS. 2A-2B) contains the transparent conductive oxide, the optical transmittance of the first area A1 may be improved. Accordingly, the electronic device 1000 (e.g., see FIG. 1) with improved performance of the camera module 430 or CMM (e.g., see FIGS. 2A-2B) may be provided.

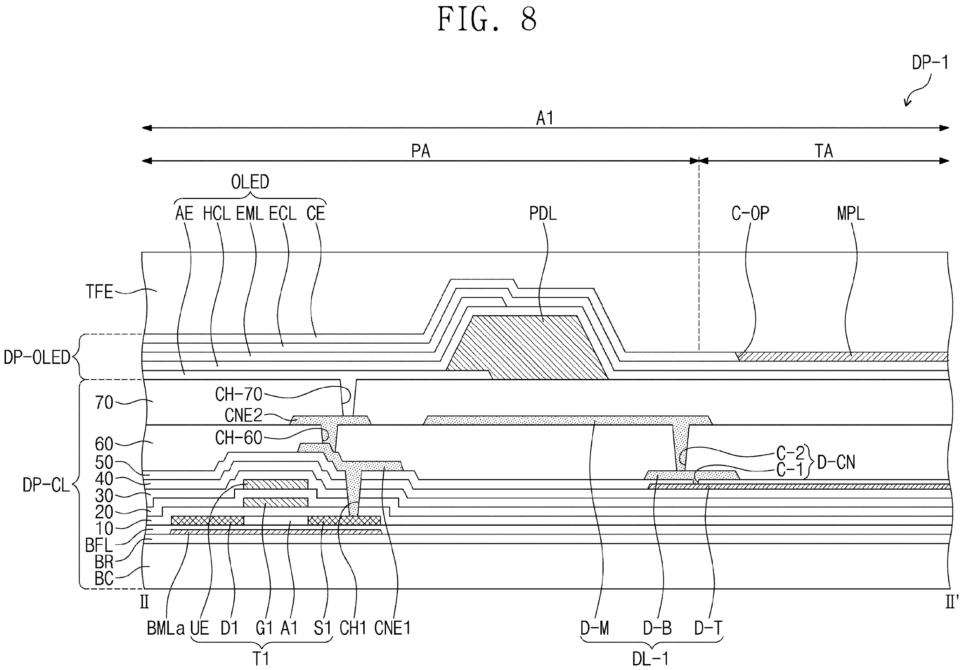

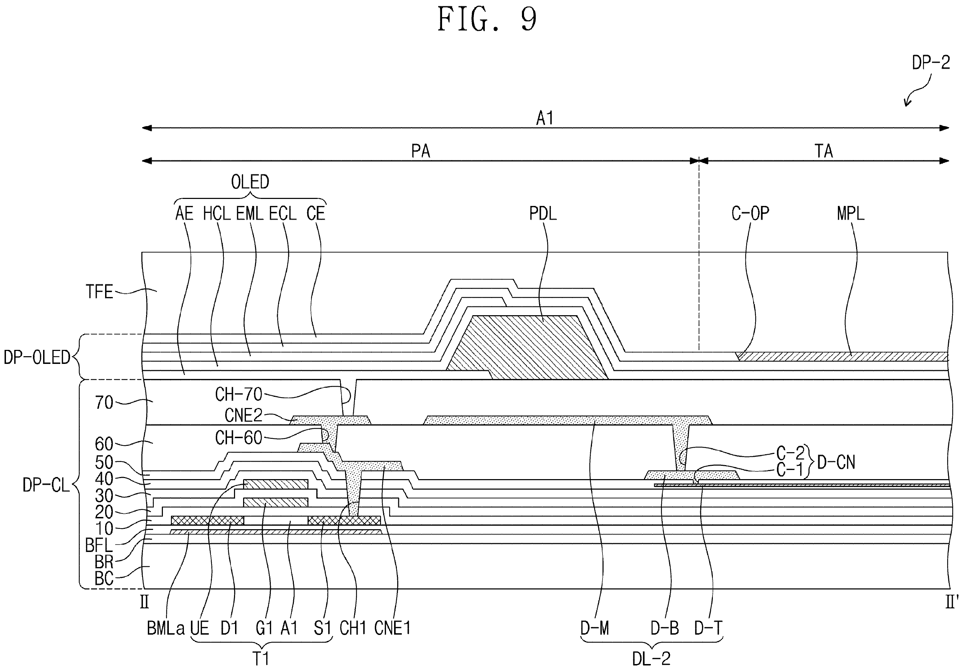

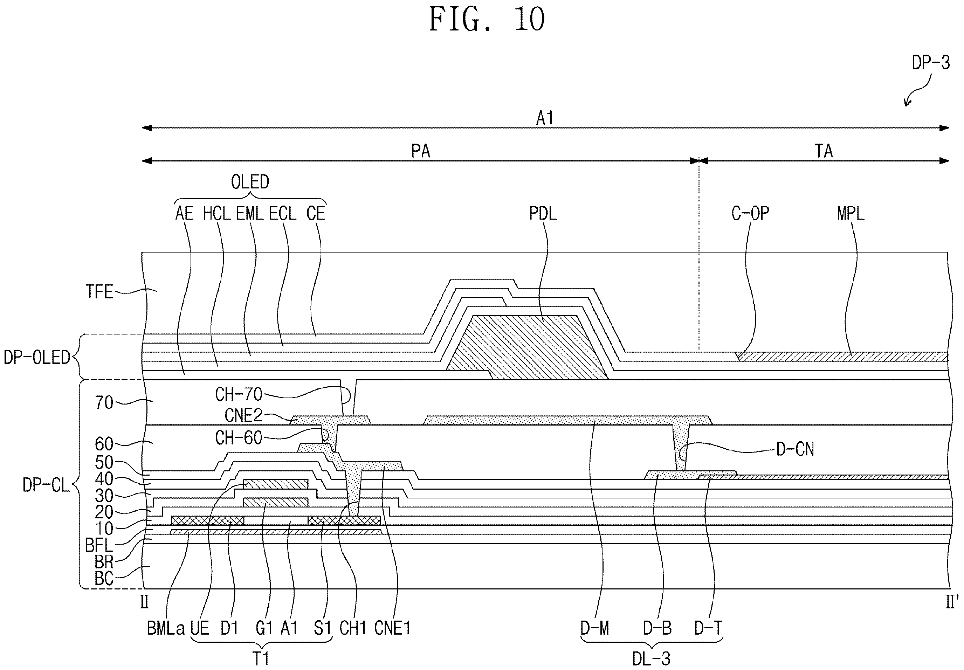

FIG. 8 is a cross-sectional view of a display panel taken along the line II-II' in FIG. 6 according to one or more embodiments of the present invention. FIG. 9 is a cross-sectional view of a display panel taken along the line II-II' in FIG. 6 according to one or more embodiments of the present invention. FIG. 10 is a cross-sectional view of a display panel taken along the line II-II' in FIG. 6 according to one or more embodiments of the present invention. The same/similar reference numerals are used for components that are the same/similar to those described in FIGS. 1 to 5, and redundant descriptions are omitted.

Referring to FIG. 8, a display panel DP-1 overlapping the first area A1 according to one or more embodiments may include the base layer BL, the circuit element layer DP-CL, the display element layer DP-OLED, and the thin film encapsulation layer TFE.

According to the present embodiment, the data line DL-2 may include the first pattern D-T and the second pattern D-M. The data line DL-2 may further include a bridge pattern D-B.

The first pattern D-T may be disposed on or above the lower insulating layer 40, and the bridge pattern D-B may be disposed on the intermediate insulating layer 50. The first pattern D-T and the bridge pattern D-B may be both disposed above the intermediate insulating layer 50, wherein in particular the bridge pattern D-B at least partially overlaps the first pattern D-T. The second pattern D-M may be disposed on the upper insulating layer 60. In other words, the first pattern D-T and the bridge pattern D-B may be located in the upper insulating layer 60.

The portion of the first pattern D-T may be disposed in the transmissive area TA, and the remaining portion of the first pattern D-T may be disposed in the circuit area PA and overlap the bridge pattern D-B and the second pattern D-M in the third direction DR3. The bridge pattern D-B and the second pattern D-M may be disposed in the circuit area PA. In one or more embodiments, the bridge pattern D-B may also be partially disposed in the transmissive area TA. The first pattern D-T may contain the transparent conductive oxide, and the second pattern D-M may contain a metal. According to the present embodiment, the second pattern D-M may be connected to the first pattern D-T via the contact hole D-CN.

For example, the bridge pattern D-B may be connected to the first pattern D-T via a first contact hole C-1 defined in the intermediate insulating layer 50, and the second pattern D-M may be connected to the bridge pattern D-B via a second contact hole C-2 defined in the upper insulating layer 60.

The bridge pattern D-B may contain the same material as the first connection electrode CNE1 and may be formed via the same process as the first connection electrode CNE1. The second pattern D-M may contain the same material as the second connection electrode CNE2 and may be formed via the same process as the second connection electrode CNE2.

Referring to FIG. 9, a display panel DP-2 overlapping the first area A1 according to one or more embodiments may include the circuit element layer DP-CL, the display element layer DP-OLED, and the thin film encapsulation layer TFE.

According to the present embodiment, the data line DL may include the first pattern D-T and the second pattern D-M. The data line DL may further include the bridge pattern D-B.

The first pattern D-T may be disposed on the lower insulating layer 40, and the bridge pattern D-B may be disposed on the intermediate insulating layer 50. The second pattern D-M may be disposed on the upper insulating layer 60.

According to one or more embodiments, the lower insulating layer 40 may be provided as a plurality of inorganic layers. For example, the lower insulating layer 40 may include a first insulating layer disposed on the third insulating layer 30 and a second insulating layer disposed on the first insulating layer. In one or more embodiments, the intermediate insulating layer 50 may include a first insulating layer disposed on the lower insulating layer 40 and a second insulating layer disposed on the first insulating layer. The first insulating layer may contain silicon oxide, and the second insulating layer may contain silicon nitride, which is denser than the first insulating layer. A thickness of the first insulating layer may be greater than a thickness of the second insulating layer.

In the present embodiment, the first pattern D-T may be disposed inside the intermediate insulating layer 50. After forming the first insulating layer, the first pattern D-T may be formed on the first insulating layer, covered by the second insulating layer, and disposed inside the intermediate insulating layer 50. Therefore, the first pattern D-T may be spaced from the lower insulating layer 40 and the upper insulating layer 60. However, in one or more embodiments, the first pattern D-T may be disposed inside the lower insulating layer 40. After forming the first insulating layer, the first pattern D-T may be formed on the first insulating layer, covered by the second insulating layer, and disposed inside the lower insulating layer 40. Therefore, the first pattern D-T may be spaced from the third insulating layer 30 and the intermediate insulating layer 50.

The portion of the first pattern D-T may be disposed in the transmissive area TA, and the remaining portion of the first pattern D-T may be disposed in the circuit area PA and overlap the bridge pattern D-B and the second pattern D-M in the third direction DR3. The bridge pattern D-B and the second pattern D-M may be disposed in the circuit area PA. In one or more embodiments, the bridge pattern D-B may also be partially disposed in the transmissive area TA. The first pattern D-T may contain the transparent conductive oxide, and the second pattern D-M may contain a metal. According to the present embodiment, the second pattern D-M may be connected to the first pattern D-T via the contact hole D-CN.

For example, the bridge pattern D-B may be connected to the first pattern D-T via the first contact hole C-1 defined in the second insulating layer of the intermediate insulating layer 50, and the second pattern D-M may be connected to the bridge pattern D-B via the second contact hole C-2 defined in the upper insulating layer 60.

The bridge pattern D-B may contain the same material as the first connection electrode CNE1 and may be formed via the same process as the first connection electrode CNE1. The second pattern D-M may contain the same material as the second connection electrode CNE2 and may be formed via the same process as the second connection electrode CNE2.

Referring to FIG. 10, a display panel DP-3 overlapping the first area A1 according to one or more embodiments may include the base layer BL, the circuit element layer DP-CL, the display element layer DP-OLED, and the thin film encapsulation layer TFE.

According to the present embodiment, the data line DL-3 may include the first pattern D-T and the second pattern D-M. The data line DL-3 may further include the bridge pattern D-B.

In the present embodiment, the first pattern D-T and the bridge pattern D-B may be disposed on the same layer and may be in direct contact with each other. The first pattern D-T and the bridge pattern D-B may be disposed on the intermediate insulating layer 50. The second pattern D-M may be disposed on the upper insulating layer 60. In the present embodiment, the bridge pattern D-B may be connected to the second pattern D-M via the contact hole D-CN defined in the upper insulating layer 60.

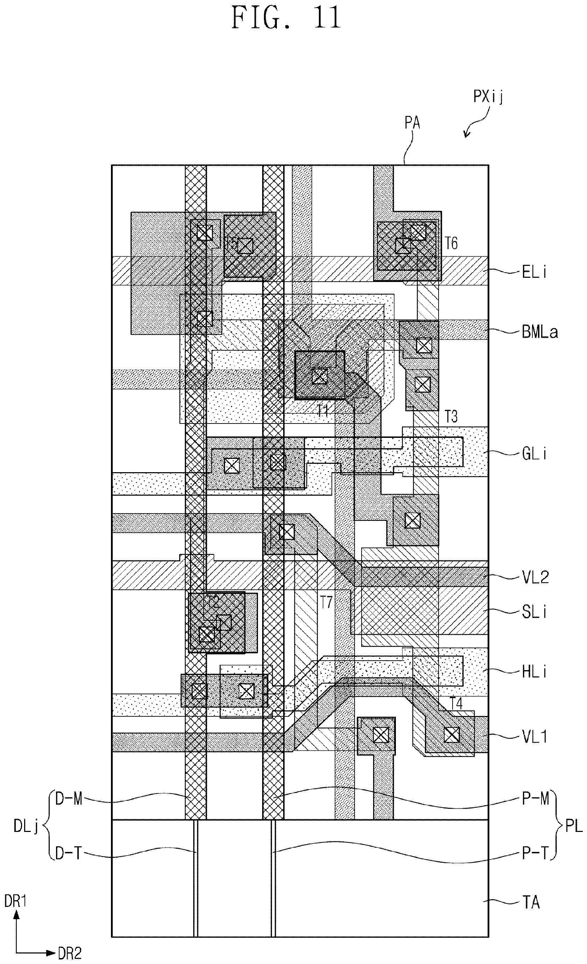

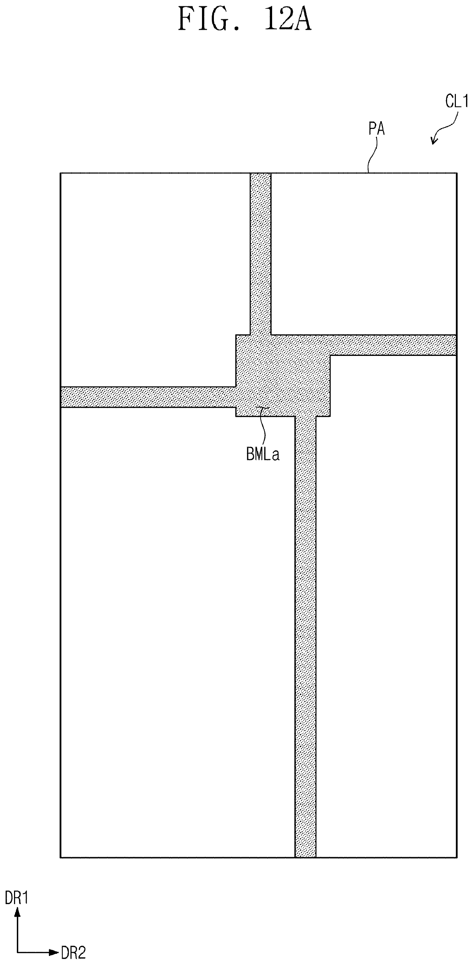

FIG. 11 is a plan view showing components included in one pixel circuit according to one or more embodiments. FIGS. 12A to 12H are plan views showing components included in one pixel circuit in a stacked order. FIG. 11 shows as an example that the pixel circuit PC (e.g., see FIG. 3B) included in the one pixel PXij is disposed in the circuit area PA. The data line DLj may include the first pattern D-T disposed in the transmissive area TA and the second pattern D-M disposed in the circuit area PA. According to one or more embodiments, the first voltage line PL may include a third pattern P-T disposed in the transmissive area TA and a fourth pattern P-M disposed in the circuit area PA.

Referring to FIGS. 11 and 12A, a first conductive layer CL1 may be disposed on the barrier layer BR (e.g., see FIG. 5). The first conductive layer CL1 may include the shielding electrode BMLa. The shielding electrode BMLa may include a portion extending in the first direction DR1 and a portion extending in the second direction DR2.

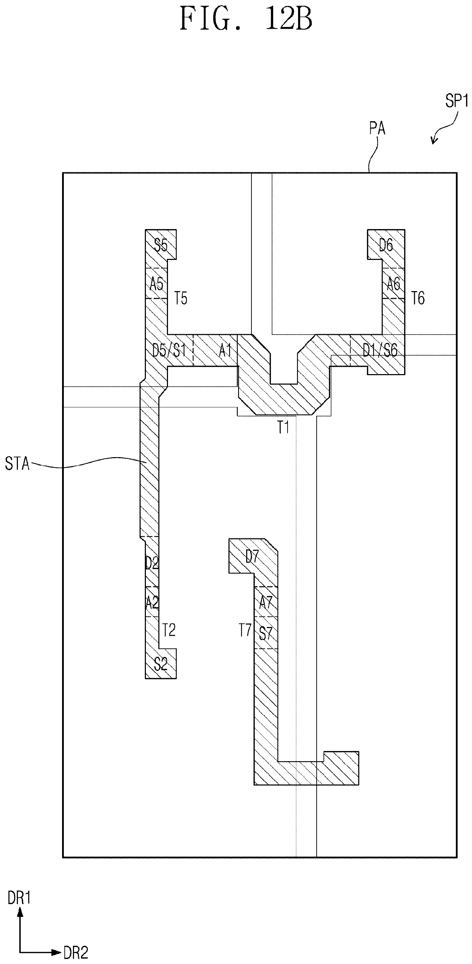

Referring to FIGS. 11 and 12B, a first semiconductor pattern SP1 may be disposed on the buffer layer BFL (e.g., see FIG. 5). In FIG. 12B, the two first semiconductor patterns SP1 are shown as examples.

The first semiconductor pattern SP1 may include a plurality of areas with different doping concentrations. The first semiconductor pattern SP1 may include the source areas S1, S2, S5, S6, and S7, the channel areas A1, A2, A5, A6, and A7, and the drain area D1, D2, D5, D6, and D7 of the first, second, fifth, sixth, and seventh transistors T1, T2, T5, T6, and T7. The first semiconductor pattern SP1 may further include a signal transmission area STA. The source areas S1, S2, S5, S6, and S7 and the drain areas D1, D2, D5, D6, and D7 may respectively correspond to the sources S1, S2, S5, S6, and S7 and the drains D1, D2, D5, D6, and D7 described with reference to FIG. 3B.

In FIG. 12B, for convenience of description, the source areas S1, S2, S5, S6, and S7 and the drain areas D1, D2, D5, D6, and D7 of adjacent semiconductor areas are shown separately from each other. In addition, the signal transmission area STA is additionally shown, but the present invention is not limited thereto. In reality, the signal transmission area STA may be an area with the same doping concentration as the source areas S1, S2, S5, S6, and S7 or the drain areas D1, D2, D5, D6, and D7, and may not be distinguished from the source areas S1, S2, S5, S6, and S7 or the drain areas D1, D2, D5, D6, and D7.

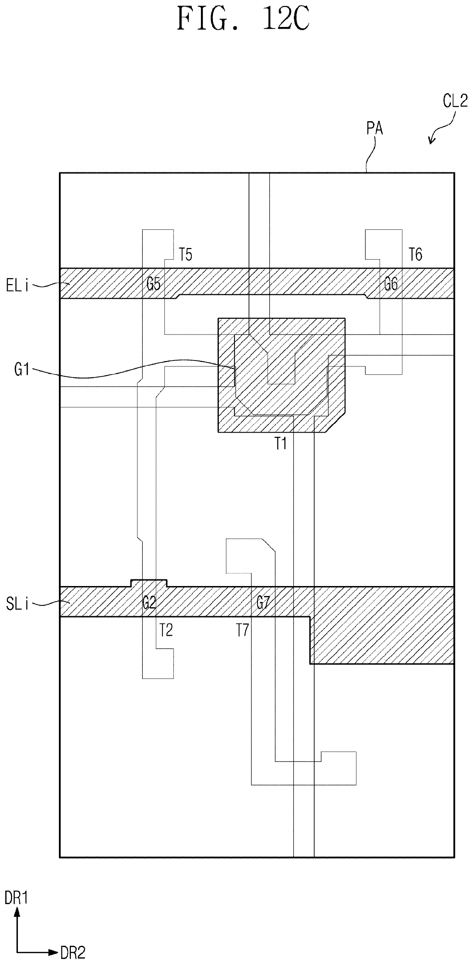

Referring to FIGS. 11 and 12C, a second conductive layer CL2 may be disposed on the first insulating layer 10 (FIG. 5). The second conductive layer CL2 may include a plurality of conductive patterns.

The second conductive layer CL2 may include the gate G1 of the first transistor T1, the i-th scan line SLi of the first group, and the i-th light emission line ELi. The i-th scan line SLi of the first group and the i-th light emission line ELi may extend in the second direction DR2.

A portion of the i-th scan line SLi of the first group overlapping the first semiconductor pattern SP1 may be the gate G2 of the second transistor T2, and another portion of the i-th scan line SLi of the first group overlapping the first semiconductor pattern SP1 may be the gate G7 of the seventh transistor T7.

A portion of the i-th light emission line ELi overlapping the first semiconductor pattern SP1 may be the gate G5 of the fifth transistor T5, and another portion thereof overlapping the first semiconductor pattern SP1 may be the gate G6 of the sixth transistor T6.

After forming the conductive pattern of the second conductive layer CL2, a doping process of the first semiconductor pattern SP1 (FIG. 12B) may be performed. Via the doping process, the source areas S1, S2, S5, S6, and S7, the channel areas A1, A2, A5, A6, and A7, and the drain areas D1, D2, D5, D6, and D7 shown in FIG. 12B may be distinguished from each other.

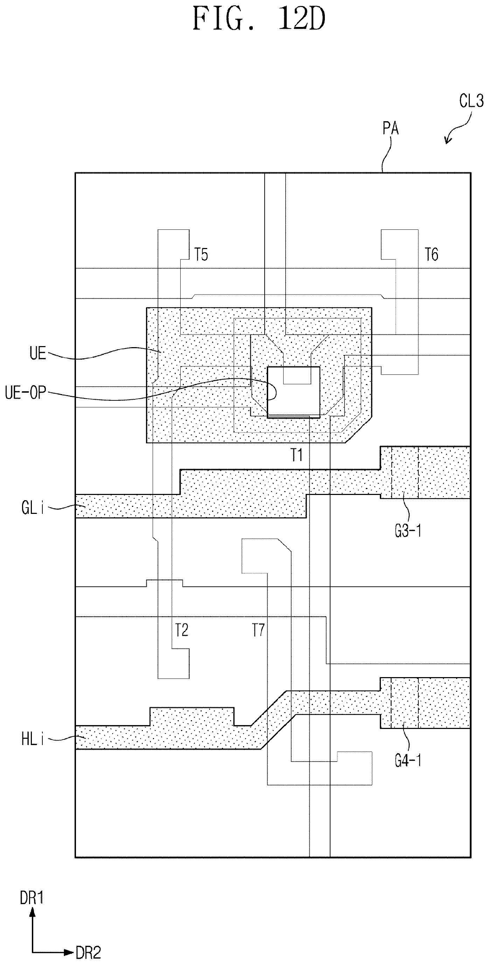

Referring to FIGS. 11 and 12D, a third conductive layer CL3 may be disposed on the second insulating layer 20 (e.g., see FIG. 5). The third conductive layer CL3 may include the upper electrode UE, the i-th scan line GLi of the second group, and the i-th scan line HLi of the third group. An opening UE-OP may be defined in the upper electrode UE. The i-th scan line GLi of the second group and the i-th scan line HLi of the third group may extend in the second direction DR2.

A portion of the i-th scan line GLi of the second group may be the third-first gate G3-1 of the third transistor T3, and a portion of the i-th scan line HLi of the third group may be the fourth-first gate G4-1 of the fourth transistor T4.

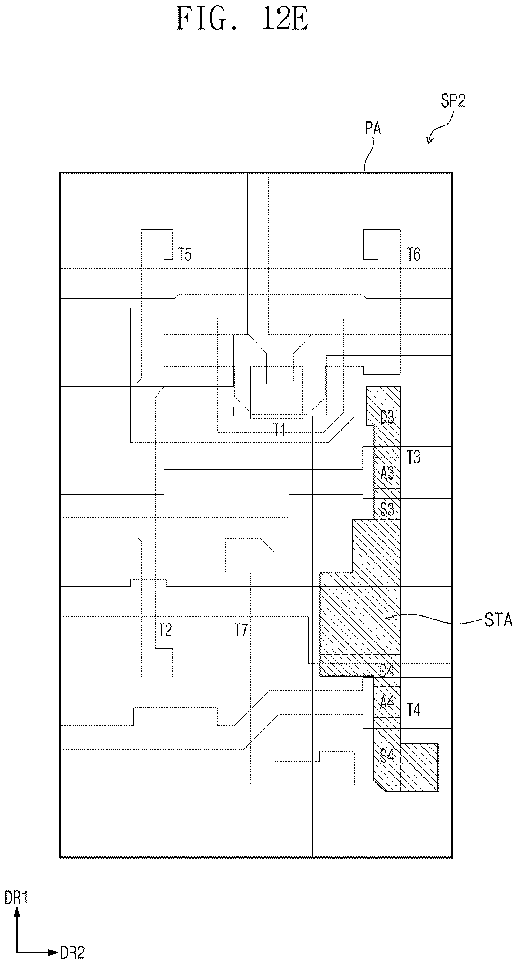

Referring to FIGS. 11 and 12E, a second semiconductor pattern SP2 may be disposed on the third insulating layer 30 (e.g., see FIG. 5). FIG. 12E shows the one second semiconductor pattern SP2 as an example.

The second semiconductor pattern SP2 may include a plurality of areas divided from each other depending on whether a metal oxide is reduced. The second semiconductor pattern SP2 may include the source areas S3 and S4, the channel areas A3 and A4, and the drain areas D3 and D4 of the third and fourth transistors T3 and T4.

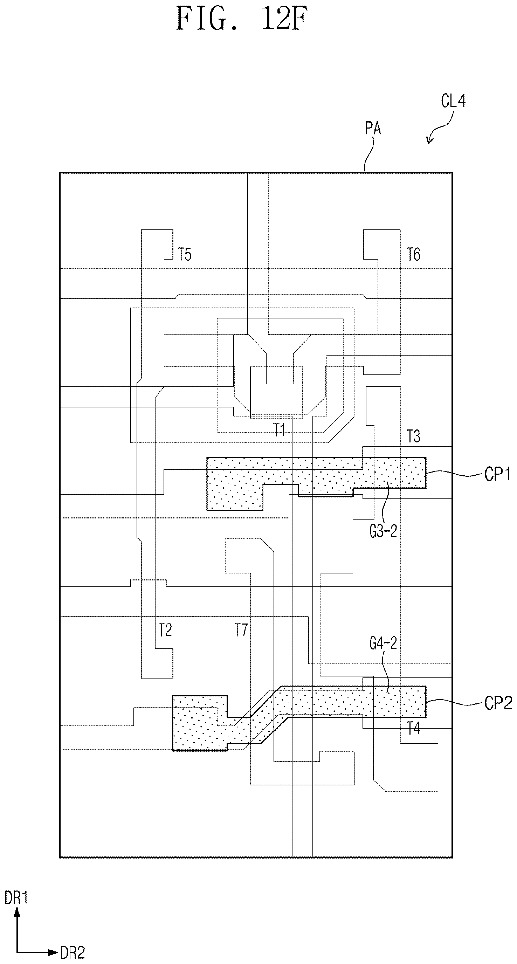

Referring to FIGS. 11 and 12F, a fourth conductive layer CL4 may be disposed on the fourth insulating layer 40 (e.g., see FIG. 5). The fourth conductive layer CL4 may include a first conductive pattern CP1 and a second conductive pattern CP2. The first conductive pattern CP1 and the second conductive pattern CP2 may include a gate of the oxide semiconductor pattern. The first conductive pattern CP1 may include an upper gate of the third transistor T3, and the second conductive pattern CP2 may include an upper gate of the fourth transistor T4. More specifically, the first conductive pattern CP1 may include a third-second gate G3-2 overlapping the channel area A3 of the third transistor T3. The second conductive pattern CP2 may include a fourth-second gate G4-2 overlapping the channel area A4 of the fourth transistor T4. After forming the conductive pattern of the fourth conductive layer CL4, a doping process (or a reduction process) of the second semiconductor pattern SP2 may be performed.

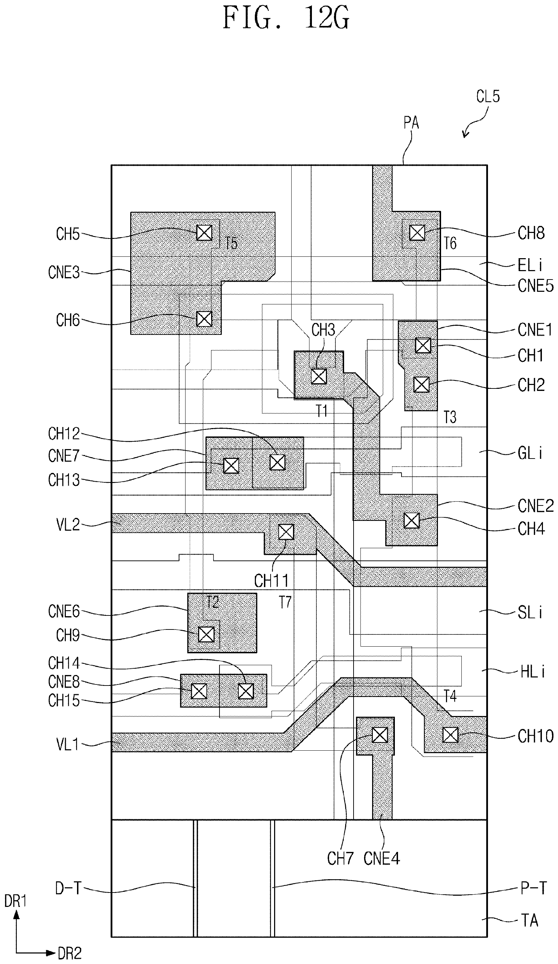

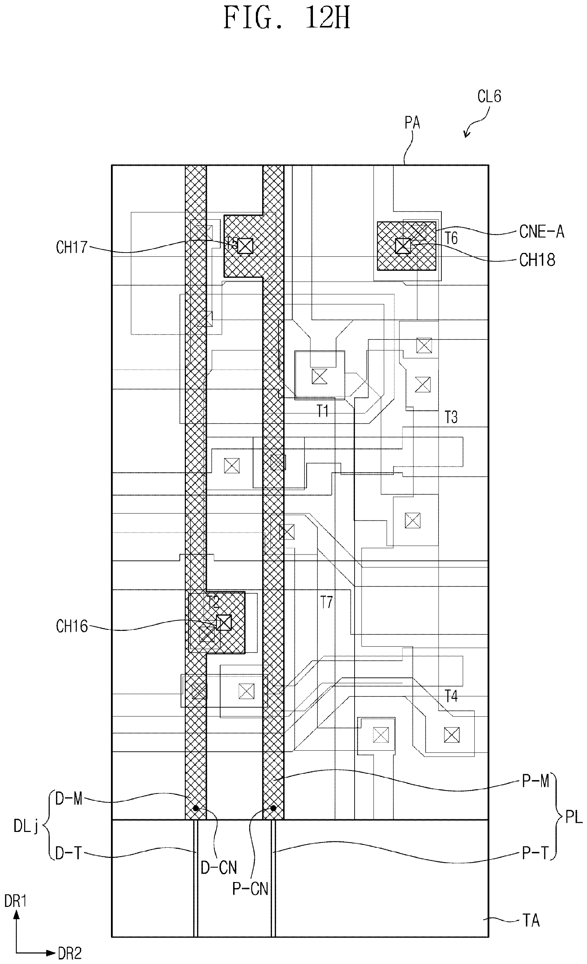

Referring to FIGS. 11, 12G, and 12H, a fifth conductive layer CL5 may be disposed on the fifth insulating layer 50 (e.g., see FIG. 5). The fifth conductive layer CL5 may include a plurality of conductive patterns.

The fifth conductive layer CL5 may include the second voltage line VL1 and the third voltage line VL2. Each of the second voltage line VL1 and the third voltage line VL2 may extend in the second direction DR2 and may be disposed adjacent to a boundary between the circuit area PA and the transmissive area TA. Additionally, the fifth conductive layer CL5 may include a plurality of connection electrodes and a plurality of contact holes. According to one or more embodiments, to improve transmittance of the transmissive area TA, the second voltage line VL1 adjacent to the boundary between the circuit area PA and the transmissive area TA may contain a transparent conductive oxide.

The first connection electrode CNE1 may connect the drain area D1 (FIG. 12B) of the first transistor T1 with the drain area D3 (FIG. 12E) of the third transistor T3 via the first contact hole CH1 and a second contact hole CH2. The second connection electrode CNE2 may connect the gate G1 (FIG. 12C) of the first transistor T1 with the source area S3 (FIG. 12E) of the third transistor T3 via a third contact hole CH3 and a fourth contact hole CH4. A third connection electrode CNE3 may connect the source area S5 (FIG. 12B) of the fifth transistor T5 with the upper electrode UE (e.g., see FIG. 12D) via a fifth contact hole CH5 and a sixth contact hole CH6.

A fourth connection electrode CNE4 may be connected to the source area S7 (FIG. 12B) of the seventh transistor T7 via a seventh contact hole CH7. The fourth connection electrode CNE4 may be electrically connected to an anode of a light emitting element in an i-1-th pixel row. A fifth connection electrode CNE5 may be connected to the drain area D6 (FIG. 12B) of the sixth transistor T6 via an eighth contact hole CH8. The fifth connection electrode CNE5 may be connected to the source area of the seventh transistor in an i+1-th pixel row.

A sixth connection electrode CNE6 may be connected to the source area S2 (FIG. 12B) of the second transistor T2 via a ninth contact hole CH9. The second voltage line VL1 may be connected to the source area S4 (FIG. 12E) of the fourth transistor T4 via a tenth contact hole CH10. The third voltage line VL2 may be connected to the drain area D7 (FIG. 12B) of the seventh transistor T7 via an eleventh contact hole CH11. The tenth contact hole CH10 and the eleventh contact hole CH11 may extend through the fifth insulating layer 50 (e.g., see FIG. 5).

A seventh connection electrode CNE7 may be connected to the first conductive pattern CP1 via a twelfth contact hole CH12. More specifically, the seventh connection electrode CNE7 may be connected to the third-second gate G3-2 overlapping the channel area A3 of the third transistor T3 formed from the first conductive pattern CP1 via the twelfth contact hole CH12. Additionally, the seventh connection electrode CNE7 may be connected to the i-th scan line GLi of the second group via a thirteenth contact hole CH13.

An eighth connection electrode CNE8 may be connected to the second conductive pattern CP2 via a fourteenth contact hole CH14. More specifically, the eighth connection electrode CNE8 may be connected to the fourth-second gate G4-2 overlapping the channel area A4 of the fourth transistor T4 formed from the second conductive pattern CP2 via the fourteenth contact hole CH14. Additionally, the eighth connection electrode CNE8 may be connected to the i-th scan line HLi of the third group via a fifteenth contact hole CH15.

As shown in FIG. 12G, before forming the fifth conductive layer CL5, a transparent conductive oxide may be applied on the fifth insulating layer 50 (e.g., see FIG. 5) to form the first pattern D-T and the third pattern P-T. The first pattern D-T and the third pattern P-T may be disposed in the transmissive area TA.

Referring to FIGS. 11 and 12H, a sixth conductive layer CL6 may be disposed on the sixth insulating layer 60 (e.g., see FIG. 5). The sixth conductive layer CL6 may include a plurality of conductive patterns. The sixth conductive layer CL6 may include the second pattern D-M included in the j-th data line DLj, the fourth pattern P-M included in a portion of the first voltage line PL, and a ninth connection electrode CNE-A. The second pattern D-M and the fourth pattern P-M may extend in the first direction DR1. The second pattern D-M may be connected to the first pattern D-T via the contact hole D-CN defined in the sixth insulating layer 60, and the fourth pattern P-M may be connected to the third pattern P-T via a contact hole P-CN defined in the sixth insulating layer 60.

According to the present embodiment, as portions overlapping the transmissive area TA of the data line DLj and the first voltage line PL crossing the transmissive area TA contain a transparent conductive oxide, the optical transmittance of the transmissive area TA may be improved.

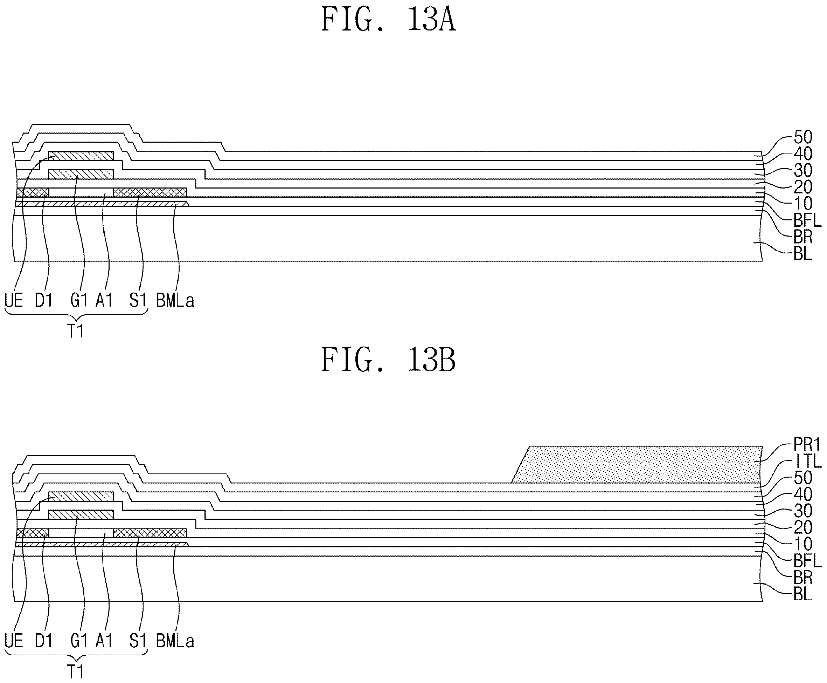

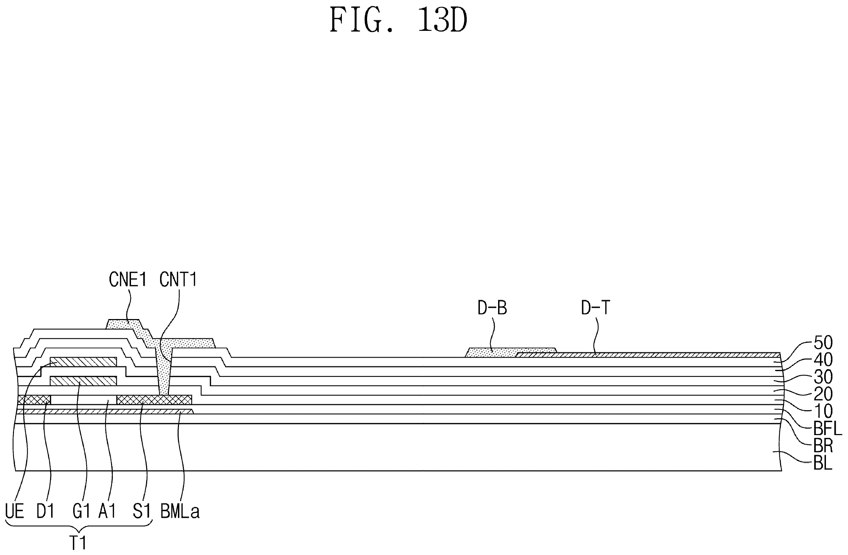

FIGS. 13A to 13H are cross-sectional views showing a method of manufacturing an electronic device according to one or more embodiments of the present invention. The same/similar reference numerals are used for components that are the same/similar to those described in FIGS. 1 to 10, and redundant descriptions are omitted. A process of forming the data line DL-3 described in FIG. 10 will be described with reference to FIGS. 13A to 13H.

Referring to FIG. 13A, the display panel manufacturing method according to one or more embodiments may include forming the transistor T1 and the insulating layers BR, BFL, and 10 to 50 on the base layer BL. The insulating layer, the semiconductor layer, and the conductive layer are formed via the coating, the deposition, and/or the like. Thereafter, the insulating layer, the semiconductor layer, and the conductive layer may be selectively patterned using the photolithography. In such scheme, the semiconductor pattern, and the conductive pattern. included in the transistor T1, the insulating layers BR, BFL, and 10 to 50, the signal line, and the like are formed.

Thereafter, referring to FIG. 13B, the display panel manufacturing method according to one or more embodiments may include forming a transparent conductive layer ITL on the fifth insulating layer 50 and forming a first photoresist layer PR1 on the transparent conductive layer ITL. The transparent conductive layer ITL may contain a transparent conductive oxide.

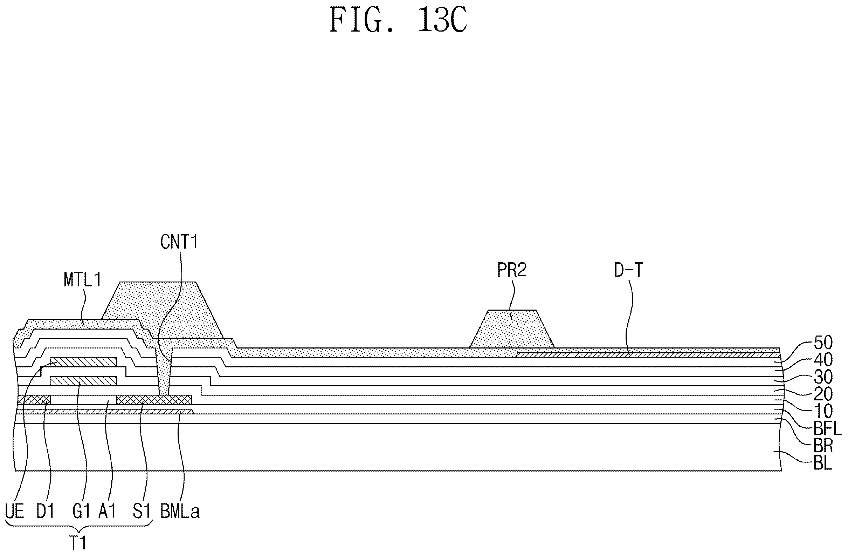

Thereafter, referring to FIG. 13C, in the display panel manufacturing method according to one or more embodiments, a wet process may be performed on the transparent conductive layer ITL using the first photoresist layer PR1 as a mask. With such process, the first pattern D-T may be formed on the fifth insulating layer 50.

Thereafter, defining a first contact hole CNT1 extending through the first to fifth insulating layers 10 to 50 overlapping the source S1 may be included. In this regard, an annealing process may be performed to dehydrogenate the semiconductor pattern included in the first transistor T1. Via the annealing process, the first pattern D-T may be crystallized.

Hereafter, referring to FIGS. 13C-13D, the display panel manufacturing method according to one or more embodiments may include forming a first conductive layer MTL1 on the fifth insulating layer 50 and forming a second photoresist layer PR2 on the first conductive layer MTL1. The first conductive layer MTL1 may be composed of sequentially stacked titanium/aluminum/titanium.

Thereafter, a dry process may be performed on the first conductive layer MTL1 using the second photoresist layer PR2 as a mask. With such process, the first connection electrode CNE1 and the bridge pattern D-B may be formed on the fifth insulating layer 50.

The first connection electrode CNE1 may be connected to the source S1 via the first contact hole CNT1. According to the present embodiment, the bridge pattern D-B may be in direct contact with the first pattern D-T.

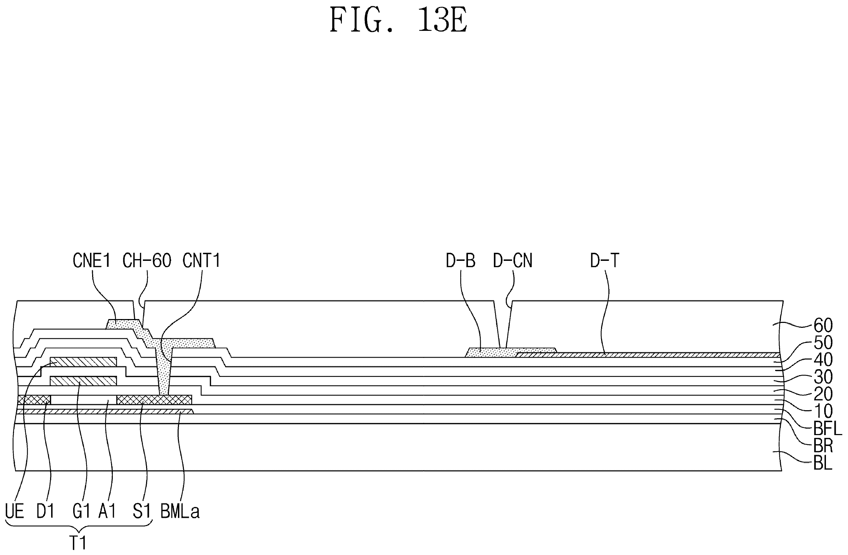

Thereafter, referring to FIG. 13E, the display panel manufacturing method according to one or more embodiments may include forming the sixth insulating layer 60 on the fifth insulating layer 50. The sixth insulating layer 60 may contain an organic material. In the sixth insulating layer 60, a second contact hole CH-60 overlapping the first connection electrode CNE1 and the contact hole D-CN overlapping the bridge pattern D-B may be defined.

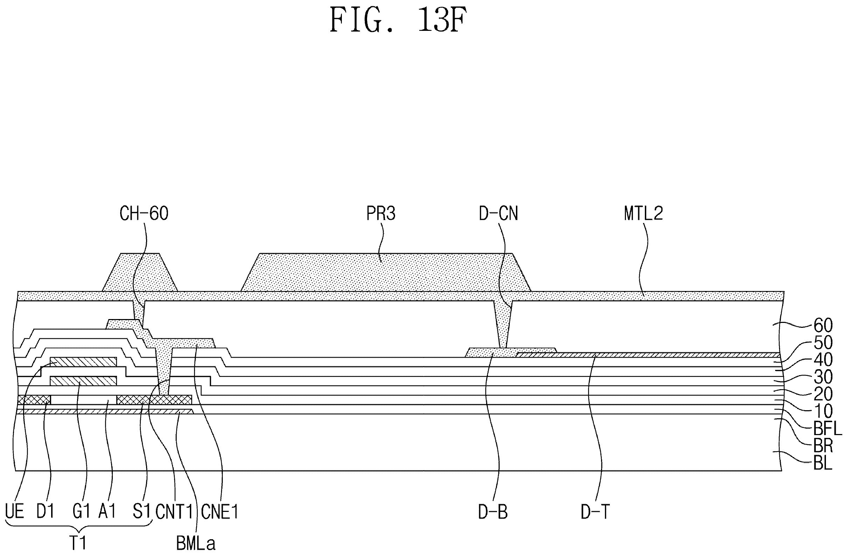

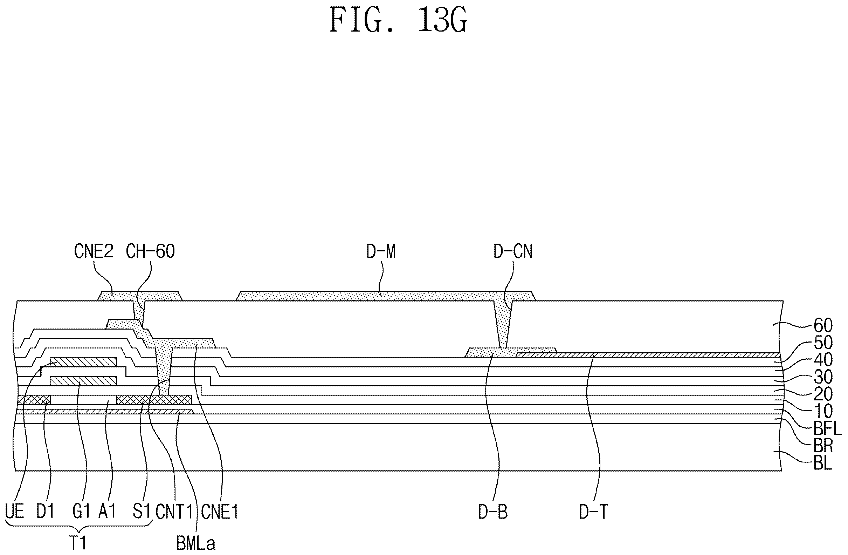

Thereafter, referring to FIGS. 13F and 13G, the display panel manufacturing method according to one or more embodiments may include forming a second conductive layer MTL2 on the sixth insulating layer 60 and forming a third photoresist layer PR3 on the second conductive layer MTL2. The second conductive layer MTL2 may be composed of sequentially stacked titanium/aluminum/titanium.

Thereafter, a dry process may be performed on the second conductive layer MTL2 using the third photoresist layer PR3 as a mask. With such process, the second connection electrode CNE2 and the second pattern D-M may be formed on the sixth insulating layer 60. The second connection electrode CNE2 may be connected to the first connection electrode CNE1 via the second contact hole CH-60, and the second pattern D-M may be connected to the bridge pattern D-B via the contact hole D-CN.

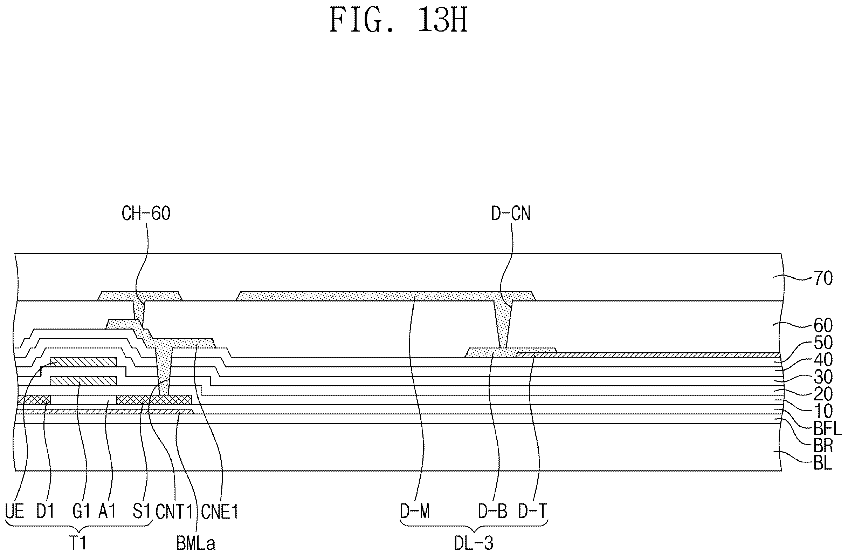

Thereafter, referring to FIG. 13H, the display panel manufacturing method according to one or more embodiments may include forming the seventh insulating layer 70 on the sixth insulating layer 60. The seventh insulating layer 70 may contain an organic material.

Although the description has been made above with reference to the one or more embodiments of the present invention, a person skilled in the art or having ordinary knowledge in the relevant technical field will understand that the present invention may be modified and changed in various ways without departing from the scope of the present invention described in the claims.

Therefore, the technical scope of the present invention should not be limited to the content described in the detailed description herein, but may be determined by the scope of the claims and their equivalents.

According to one or more embodiments of the present invention, as the portion of the data line disposed within the transmissive area contains the transparent conductive oxide, the optical transmittance of one area of the active areas may be improved.

While the present invention has been described with reference to embodiments thereof, it will be apparent to those of ordinary skill in the art that various changes and modifications may be made thereto without departing from the scope of the present invention as set forth in the following claims.

## Claims

1. An electronic device (1000) comprising:
a base layer (BL) including a first area (A1) and a second area (A2) having a lower optical transmittance than the first area (A1);
a first group of pixels in the first area (A1) and a second group of pixels in the second area (A2), wherein each pixel from among the first group of pixels and the second group of pixels comprises a pixel circuit (PC) comprising transistors (T1 to T7) and conductive patterns (MS1, MS2) and a light emitting element (OLED) connected to the pixel circuit (PC); and
data lines (DL) extending in a first direction (DR1), each of the data lines (DL) being connected to the pixel circuits (PC) arranged along the first direction (DR1),
wherein the first area (A1) includes circuit areas (PA) and transmissive areas (TA) arranged alternately along the first direction (DR1) and extending in a second direction (DR2) intersecting the first direction (DR1),
wherein the pixel circuits (PC) in the first group of pixels in the circuit areas (PA) are spaced from the transmissive areas (TA),
wherein the data lines (DL) comprise first patterns (D-T) at least partially overlapping the transmissive areas (TA) and second patterns (D-M) overlapping the circuit areas (PA), and
wherein the first patterns (D-T) and the second patterns (D-M) comprise different materials.

2. The electronic device (1000) of claim 1, wherein the first patterns (D-T) comprise a transparent conductive oxide,
wherein the second patterns (D-M) comprise sequentially stacked first layer, second layer, and third layer, and
wherein the first layer and the third layer comprise titanium, and the second layer comprises aluminum.

3. The electronic device (1000) of claim 1 or 2, further comprising:
a lower insulating layer (40) covering the first patterns (D-T);
an intermediate insulating layer (50) on the lower insulating layer (40), the second patterns (D-M) being on the intermediate insulating layer (50); and
an upper insulating layer (60) on the intermediate insulating layer (50) and covering the second patterns (D-M).

4. The electronic device (1000) of claim 3, wherein the second patterns (D-M) are connected to the first patterns (D-T) via a contact hole (D-CN) in the lower insulating layer (40) and the intermediate insulating layer (50).

5. The electronic device (1000) of claim 3 or 4, further comprising:
a bridge pattern (D-B) located on the lower insulating layer (40) overlapping the circuit areas (PA) and between the corresponding first pattern and the corresponding second pattern of the first patterns (D-T) and the second patterns (D-M),
wherein the bridge pattern (D-B) is connected to the first pattern via a first contact hole (D-CN) in the lower insulating layer (40), and the second pattern is connected to the bridge pattern (D-B) via a second contact hole (D-CN) in the intermediate insulating layer (50).

6. The electronic device (1000) of at least one of claims 3 to 5, wherein the first patterns (D-T) are inside the lower insulating layer (40).

7. The electronic device (1000) of at least one of claims 3 to 6, wherein the lower insulating layer (40) comprises a first insulating layer comprising silicon oxide, and a second insulating layer on the first insulating layer and comprising silicon nitride,
wherein the first patterns (D-T) are on the first insulating layer and covered by the second insulating layer.

8. The electronic device (1000) of claim 7, wherein a thickness of the first insulating layer is greater than a thickness of the second insulating layer.

9. The electronic device (1000) of claim 3, further comprising:
a bridge pattern (D-B) on the lower insulating layer (40) and in direct contact with a corresponding first pattern of the first patterns (D-T),
wherein a second pattern of the second patterns (D-M) is connected to the bridge pattern (D-B) via a contact hole (D-CN) in the intermediate insulating layer (50).

10. The electronic device (1000) of at least one of claims 1 to 9, wherein each of the light emitting elements (OLED) comprises a first electrode (CE10), a second electrode (CE) on the first electrode (CE10), and a light emitting layer between the first electrode (CE10) and the second electrode (CE),
wherein the second electrode (CE) is common to the light emitting elements (OLED).

11. The electronic device (1000) of claim 10, wherein electrode holes (C-OP) penetrating the second electrode (CE) are in the second electrode (CE) overlapping the transmissive areas (TA).

12. The electronic device (1000) of claim 11, further comprising:
coating patterns in the electrode holes (C-OP).

13. The electronic device (1000) of claim 12, wherein each of the coating patterns has a circular shape or a polygonal shape.

14. The electronic device (1000) of claim 12 or 13, wherein at least one portion of the first pattern overlaps the corresponding coating pattern.

15. The electronic device (1000) of at least one of claims 1 to 14, wherein each of the first group of pixels and the second group of pixels has unit pixels arranged along the first direction (DR1),
wherein the unit pixels comprise a first pixel configured to emit a first color light, a second pixel configured to emit a second color light, a third-first pixel configured to emit a third color light, and a third-second pixel configured to emit the third color light,
wherein the first pixel and the second pixel are spaced from each other along the second direction (DR2), and the third-first pixel and the third-second pixel are spaced from each other in a diagonal direction intersecting the first direction (DR1) and the second direction (DR2), with the first pixel in between.

16. The electronic device (1000) of claim 15, wherein some of the pixel circuits (PC) in the second group of pixels are aligned with the transmissive areas (TA) along the second direction (DR2).

17. The electronic device (1000) of at least one of claims 1 to 16, wherein some of the transistors (T1 to T7) comprise an oxide semiconductor pattern and some other ones of the transistors (T1 to T7) comprise a silicon semiconductor pattern.

18. The electronic device (1000) of at least one of claims 1 to 17, further comprising:
a camera module (430) under the base layer (BL) and overlapping the second area (A2).

19. The electronic device (1000) of at least one of claims 1 to 18, wherein the base layer (BL) further includes a hole area (AH) having higher optical transmittance than the first area (A1) and extending through at least a portion of the base layer (BL),
wherein the electronic device (1000) further comprises at least one infrared ray sensor under the base layer (BL) and overlapping the hole area (AH).
